(19) Europäisches Patentamt
European Patent Office
Office européen des brevets

(11) **EP 4 105 173 B1**

(12) **EUROPEAN PATENT SPECIFICATION**

(45) Date of publication and mention
of the grant of the patent:
**22.04.2026 Bulletin 2026/17**

(21) Application number: **21770425.3**

(22) Date of filing: **18.03.2021**

(51) International Patent Classification (IPC):
*C01B 21/06* (2006.01)     *C01B 21/064* (2006.01)
*H01L 23/36* (2006.01)     *H01L 23/373* (2006.01)
*C08L 83/05* (2006.01)     *C08L 83/07* (2006.01)
*C08K 3/013* (2018.01)     *H05K 7/20* (2006.01)
*C08K 3/22* (2006.01)      *C08L 83/04* (2006.01)
*C08K 3/38* (2006.01)

(52) Cooperative Patent Classification (CPC):
(C-Sets available)
**H10W 40/251; C01B 21/064; C08L 83/04;**
C01P 2004/54; C01P 2004/61; C01P 2006/32;
C01P 2006/40; C08K 2003/2227; C08K 2003/385;
C08K 2201/003                                    (Cont.)

(86) International application number:
**PCT/JP2021/011255**

(87) International publication number:
**WO 2021/187609 (23.09.2021 Gazette 2021/38)**

(54) **HEAT DISSIPATION SHEET AND METHOD FOR MANUFACTURING HEAT DISSIPATION SHEET**

WÄRMEABLEITUNGSFOLIE UND VERFAHREN ZUR HERSTELLUNG EINER WÄRMEABLEITUNGSFOLIE

FEUILLE DE DISSIPATION DE CHALEUR ET MÉTHODE DE FABRICATION D'UNE FEUILLE DE DISSIPATION DE CHALEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.03.2020   JP 2020049711**
**19.03.2020   JP 2020049717**
**19.03.2020   JP 2020049718**
**19.03.2020   JP 2020049723**

(43) Date of publication of application:
**21.12.2022 Bulletin 2022/51**

(73) Proprietor: **Denka Company Limited**
**Tokyo 103-8338 (JP)**

(72) Inventors:
• **WADA, Kosuke**
**Tokyo 103-8338 (JP)**
• **TANIGUCHI, Yoshitaka**
**Tokyo 103-8338 (JP)**

(74) Representative: **Gulde & Partner**
**Patent- und Rechtsanwaltskanzlei mbB**
**Berliner Freiheit 2**
**10785 Berlin (DE)**

(56) References cited:
EP-A1- 3 522 689        EP-A1- 4 002 443
WO-A1-2018/061447       WO-A1-2019/164002
WO-A1-2019/164002       WO-A1-2021/039500
WO-A1-2021/039500       JP-A- 2011 096 989
JP-A- 2019 010 773      JP-A- 2019 172 935

(52) Cooperative Patent Classification (CPC): (Cont.)

C-Sets
**C08L 83/04, C08L 83/04, C08K 3/38;**
**C08L 83/04, C08L 83/04, C08K 3/38, C08K 3/22;**
**C08L 83/04, C08L 83/04, C08K 3/38, C08K 3/36**

**Description**

Technical Field

The present invention relates to a heat dissipation sheet used between an electronic component and a heat sink for cooling the electronic component or a heat dissipation portion of a circuit board, and a method for producing the heat dissipation sheet.

Background Art

At present, heat-generating electronic components such as power devices, transistors, thyristors, and CPUs are mounted on various devices, and their application fields are diversified.

These heat-generating electronic components generate heat due to internal resistance when a current is passed therethrough, and the operation speed is lowered to cause an operation failure. In addition, when heat is generated more than expected, the heat-generating electronic components may be broken or may ignite.

Conventionally, heat sinks made of metals such as iron, aluminum, and cupper having high thermal conductivities (80 to 400 W/mK) have been used as measures for efficiently dissipating heat generated when electronic components are used. The heat dissipation characteristics of the heat sink are evaluated by thermal resistance, and the smaller this value, the higher the heat dissipation characteristics. In order to reduce the value of thermal resistance, the arrangement of a plurality of fins or pins is designed so that the surface area is large and the fluidity of air is high.

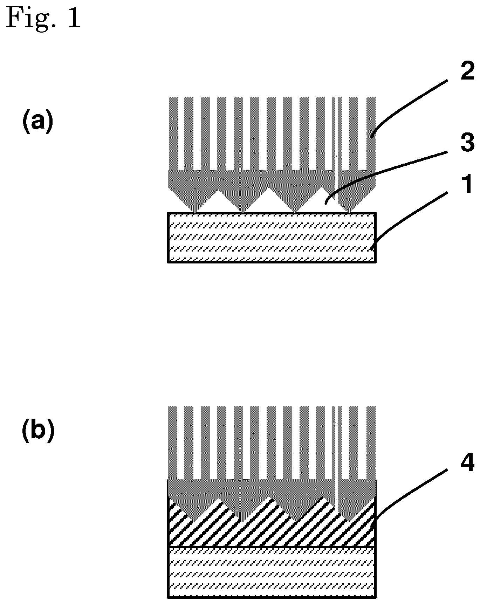

However, even if such a heat sink having a high heat dissipation characteristic is used, when the heat sink is attached in direct contact with an electronic component, an air layer having a low thermal conductivity (0.02 W/mK) exists at a contact interface, and as a result, sufficient heat dissipation efficiency cannot be obtained. Therefore, the heat sink and the electronic component are brought into close contact with each other via a heat dissipation sheet (Fig. 1). As such a heat dissipation sheet, a sheet in which a thermally conductive filler is dispersed in a silicone resin is used.

Examples of such a thermally conductive filler include aluminum oxide, magnesium oxide, boron nitride, aluminum nitride, silicon nitride, silicon carbide, metal aluminum, and graphite (JP 2014-229849 A).

In particular, primary particles of hexagonal boron nitride (h-BN) have a scale-like crystal structure, are chemically very stable, have high thermal conductivity, electrical insulation, and heat resistance, and are used as a thermally conductive filler (JP 2018-104253 A). Due to its crystalline structure, h-BN has a thermal conductivity of 400 W/mK in the in-plane direction (also referred to as a-axis direction) and a thermal conductivity of 2 W/mK in the thickness direction (also referred to as c-axis direction), and the anisotropy of the thermal conductivity is remarkably large. Therefore, JP 2018-104253 A proposes the use of a primary particle aggregate in which scale-like primary particles of h-BN are aggregated so as not to be oriented in the same direction, in order to eliminate the anisotropy of thermal conductivity.

On the other hand, JP 2012-039060 A proposes a thermally conductive sheet excellent in thermal conductivity in the plane direction by using scale-like primary particles of h-BN which are not aggregated. Additionally,

WO 2019/164002 A1 and EP 3 522 689 A1 both disclose a heat dissipation sheet containing a silicone resin and a thermally conductive filler, being aggregated hexagonal boron nitride particles.

Summary of Invention

Technical Problem

Electronic components such as power devices, transistors, thyristors, and CPUs are often used in in-vehicle applications. In particular, power devices have the functions of rectification, frequency conversion, regulators, and inverters, and can control and supply power, and in recent years, there has been increasing interest in SiC power devices mainly for in-vehicle applications.

The heat dissipation sheet is required to have high thermal conductivity and high insulating property. When the dielectric breakdown voltage is low, insulation failure is likely to occur in the heat dissipation sheet, which leads not only to damage to electronic components but also to accidents of machines and vehicles in which the heat dissipation sheet is mounted.

Usually, the fastening pressure when the heat sink is attached to the electronic component is about 0.2 to 0.4 MPa. However, in the case of in-vehicle use, it is desirable to increase the fastening pressure to about 1.0 MPa in order to prevent vibration during traveling.

The present inventors have confirmed that in a heat dissipation sheet using non-aggregated h-BN primary particles, thermal resistance increases when the fastening pressure is increased from 0.2 to 0.4 MPa to about 1.0 MPa. It is considered that collapse of the heat conduction path (for example, breakage of the thermally conductive filler) occurred inside the sheet.

It is therefore an object of the present invention to provide a heat dissipation sheet which exhibits excellent thermal conductivity and insulating property even under high pressure, and a method for producing the heat dissipation sheet, assuming that it is used for in-vehicle applications.

Solution to Problem

The invention is defined by the appended claims. The description that follows is subjected to this limitation. Any disclosure lying outside the scope of said claims is only intended for illustrative as well as comparative purposes.

The present invention provides a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler.

In this case, according to a first aspect of the present invention, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters, if the average value of an aspect ratio is in the range of 0.4 or more and 1.4 or less, the dielectric breakdown voltage measured in accordance with JIS C2110 is 5 kV or more, and the thermal resistance measured in accordance with ASTM D5470 is 1.5°C/W or less at a fastening pressure of 1.0 MPa.

Further, in this case, according to a second aspect of the present invention, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters, if the average value of an aspect ratio is in the range of 0.4 or more and 1.4 or less, the dielectric breakdown voltage measured in accordance with JIS C2110 is 5 kV or more, and the thermal resistance measured in accordance with ASTM D5470 is 1.5°C/W or less at a fastening pressure of 1.0 MPa.

Furthermore, in this case, according to a third aspect of the present invention, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters, if a particle number ratio, $n_w/n_d$, of a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, is in the range of 0.4 or more and less than 1, the dielectric breakdown voltage measured in accordance with JIS C2110 is 5 kV or more, and the thermal resistance measured in accordance with ASTM D5470 is 1.5°C/W or less at a fastening pressure of 1.0 MPa.

In this case, according to a fourth aspect of the present invention, when the heat dissipation sheet is actually used between the electronic component and the heat dissipation portion, it is preferable that the heat dissipation sheet is thin from the viewpoint of thermal resistance, but it is preferable that the heat dissipation sheet is thick from the viewpoint of insulating property. In the present invention, the thermal resistance value is measured when a sheet having a thickness of 0.3 mm is formed because the balance between thermal resistance and insulating property is the best.

In general practical use, when the fastening pressure is as high as 0.8 MPa or more, the sheet thickness is reduced and the adhesion between the electronic component and the heat dissipation portion is increased, so that the thermal resistance is reduced. However, since the filler inside the particles is greatly deformed or the sheet strength is not sufficient and the sheet is broken or cracked, there is a possibility that the thermal resistance is increased and the insulating property is significantly deteriorated. Therefore, a high fastening pressure cannot be applied to the conventional heat dissipation sheet.

On the other hand, when the fastening pressure is as low as 0.4 MPa or less, the sheet thickness is not so thin and the adhesion is low, so that the thermal resistance is high. Since the deformation of the filler inside the particle is small, the possibility that the sheet is broken or cracked is extremely small. However, when the sheet is used in a state where the fastening pressure is low when application of the sheet as an in-vehicle component is examined, the component may be displaced or detached, which causes a failure during traveling.

From such a viewpoint, products that exhibit low thermal resistance despite low to high fastening pressures are ideal. In particular, it is necessary to pay attention to the thermal resistance ratio $R_{0.4}/R_{1.0}$ between the thermal resistance value $R_{0.4}$ when a pressure of 0.4 MPa is applied and the thermal resistance value $R_{1.0}$ when a pressure of 1.0 MPa is applied in the thickness direction, because the demand for a product which shows low thermal resistance without breaking or cracking even under high fastening pressure has increased more than before.

If the thermal resistance ratio $R_{0.4}/R_{1.0}$ exceeds 1, it means that the thermal resistance decreases as the fastening pressure increases from 0.4 MPa to 1.0 MPa, that is, the thermal conductivity is improved. On the other hand, if the thermal resistance ratio is less than 1, it means that the thermal resistance increases as the fastening pressure is increased, that is, the thermal conductivity is deteriorated, which suggests that the heat conduction path is collapsed inside the sheet.

At this time, when the ratio of the thermal resistance $R_{0.4}$ measured at a fastening pressure of 0.4 MPa to the thermal resistance $R_{1.0}$ measured at a fastening pressure of 1.0 MPa in accordance with ASTM D5470 (thermal resistance ratio $R_{0.4}/R_{1.0}$) is in a range exceeding 1, the dielectric breakdown voltage measured in accordance with JIS C2110 is equal to or higher than 5 kV.

The method for producing a heat dissipation sheet according to the first to third aspects of the present invention includes:

a composition preparing step of preparing a composition by mixing 10 to 30% by mass of the silicone resin and 70 to 90% by mass of the thermally conductive filler based on 100% by mass of the total amount of the silicone resin and the thermally conductive filler;

a sheet forming step of forming the composition into a sheet after the composition preparing step;

a preheating step of preheating the sheet at a preheating temperature lower than a curing starting temperature while pressurizing the sheet after the sheet forming step; and

a curing step of heating the preheated sheet at a temperature equal to or higher than the curing starting temperature while pressurizing the sheet after the preheating step.

The method for producing a heat dissipation sheet according to the fourth aspect (not falling under the protection scope of the present invention) of the present invention includes:

a composition preparing step of preparing a composition by mixing 10 to 40% by mass of the silicone resin and 60 to 90% by mass of the thermally conductive filler based on 100% by mass of the total amount of the silicone resin and the thermally conductive filler;

a sheet forming step of forming the composition into a sheet after the composition preparing step;

a preheating step of preheating the sheet at a preheating temperature lower than a curing starting temperature while pressurizing the sheet after the sheet forming step; and

a curing step of heating the preheated sheet at a temperature equal to or higher than the curing starting temperature while pressurizing the sheet after the preheating step.

Advantageous Effects of Invention

The heat dissipation sheet of the present invention has a high dielectric breakdown voltage and good thermal resistance even when the fastening pressure is increased to about 1.0 MPa, and therefore exhibits excellent characteristics even when used in in-vehicle applications.

Brief Description of Drawings

Fig. 1 is a schematic diagram illustrating a usage mode of a heat dissipation sheet.

Fig. 2 is a schematic diagram illustrating anisotropy of thermal conductivity of scale-like primary particles (a) of hexagonal boron nitride (h-BN) and aggregate particles (b) obtained by aggregating the primary particles into a lump.

Fig. 3 is a schematic diagram illustrating a particle observation method according to the present invention.

Description of Embodiments

1. First Aspect

[Heat Dissipation Sheet of First Aspect]

The heat dissipation sheet according to a first aspect of the present invention is a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I), the average value of an aspect ratio represented by formula (II) is in a range of 0.4 or more and 1.4 or less.

$$(D + W)/2 \qquad (I)$$

$$D/W \qquad (II)$$

(Constituents of Heat Dissipation Sheet)

<Composition for Heat Dissipation Sheet>

The silicone resin used in the heat dissipation sheet according to the first aspect of the present invention is an organopolysiloxane and may be linear or branched as long as it has at least two alkenyl groups directly bonded to a silicon atom in one molecule. The organopolysiloxane may be one type or a mixture of two or more types having different viscosities. Examples of the alkenyl group include a vinyl group, an allyl group, a 1-butenyl group, and a 1-hexenyl group. In general, a vinyl group is preferable in terms of ease of synthesis and cost. Examples of the other organic group bonded to a silicon atom include alkyl groups such as a methyl group, an ethyl group, a propyl group, a butyl group, a hexyl group, and a dodecyl group; aryl groups such as a phenyl group; aralkyl groups such as a 2-phenylethyl group and a 2-phenylpropyl group; and substituted hydrocarbon groups such as a chloromethyl group and a 3,3,3-trifluoropropyl group. Among these, a methyl group is preferable. The alkenyl group bonded to a silicon atom may be present either at a terminal or in the middle of the molecular chain of the organopolysiloxane.

When the silicone resin is a two-component type, an example of the crosslinking agent for the organopolysiloxane described above is an organohydrogenpolysiloxane. Examples of the organohydrogenpolysiloxane include those having at least two, preferably three or more, hydrogen atoms bonded to a silicon atom in one molecule, and may be linear, branched, or cyclic.

As the thermally conductive filler to be used in the heat dissipation sheet according to the first aspect of the present invention, a substance having a thermal conductivity exceeding 10 W/m K is preferable, and examples thereof include metal oxides such as alumina, silica, and titanium dioxide; nitrides such as aluminum nitride, boron nitride, and silicon nitride; silicon carbide; and aluminum hydroxide, which can be used alone or in combination of several kinds thereof.

Among them, alumina, silica, and boron nitride are preferable, and hexagonal boron nitride (h-BN) which is stable in terms of energy is particularly preferable.

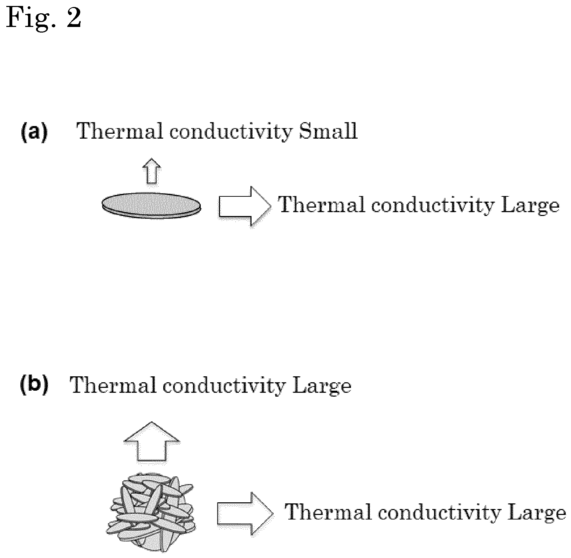

The primary particles of hexagonal boron nitride (h-BN) are scale-like and have large anisotropy in thermal conductivity (Fig. 2a). By controlling the orientation of the primary particles constituting the aggregate, the anisotropy of the aggregate as a whole can be changed. Although the anisotropy is not reduced even if the filling rate is increased to 70% by mass by simply aggregating the scale-like primary particles (see Kenji Mimura, "High Heat Conduction Composite Material", Network Polymer, Vol. 35, No. 2 (2014), pp. 76-82), for example, by preparing a primary particle aggregate in which the hexagonal boron nitride primary particles are aggregated so as not to be oriented in the same direction by the method described in JP 2018-104253 A, it is possible to improve the isotropy of the thermal conductivity of the aggregate as a whole (Fig. 2b).

In the case of aggregate particles, the aggregation force is not particularly limited, and it is sufficient that the aspect ratio D/W can be adjusted to a desired range by a production method described later. The crushing strength of the aggregate particles is 1 MPa or more, preferably 3 MPa or more, and more preferably 5 MPa or more. The upper limit is from the viewpoint of manufacturability and the like 40 MPa or less, preferably 30 MPa or less, and is, for example, 20 MPa or less, or 15 MPa or less. Thus, a range of the crushing strength of the aggregate particles is 1 to 40 MPa, for example, 1 to 30 MPa, 1 to 20 MPa, or 1 to 15 MPa.

The crushing strength is measured in accordance with JIS R1639-5 using a commercially available compression tester capable of measuring the crushing strength of fine particles. At this time, when the particle diameter of the aggregate of hexagonal boron nitride primary particles is d (unit: mm) and the breaking test force is P (unit: N), the crushing strength Cs (unit: MPa) is calculated from the equation $Cs = 2.48P/\pi d^2$. In the first aspect of the present invention, the average value of the crushing strengths of 10 aggregate particles is defined as the crushing strength.

The average particle diameter of the thermally conductive filler is preferably 5 to 90 $\mu$m. When the average particle diameter of the thermally conductive filler is 5 $\mu$m or more, the content of the thermally conductive filler can be increased. On the other hand, when the average particle diameter of the thermally conductive filler is 90 $\mu$m or less, the thickness of the heat dissipation sheet can be reduced. From such a viewpoint, the average particle diameter of the thermally conductive filler is more preferably 10 to 70 $\mu$m, still more preferably 15 to 50 $\mu$m, and particularly preferably 15 to 45 $\mu$m. The average particle diameter of the thermally conductive filler can be measured using, for example, a laser diffraction scattering particle size distribution measuring apparatus (LS-13 320) manufactured by Beckman Coulter, Inc. As the average particle diameter of the thermally conductive filler, a value measured without using a homogenizer before the measurement treatment can be adopted. Therefore, when the thermally conductive filler is aggregate particles, the average particle diameter of the thermally conductive filler is the average particle diameter of the aggregate particles. The obtained average particle diameter is, for example, an average particle diameter based on a volume statistical value.

In addition, in the case of a substance in which primary particles have a scale-like crystal shape such as hexagonal boron nitride, the "average particle diameter" means an average particle diameter of aggregate particles which are aggregated in an orderly or disorderly orientation.

The content of the silicone resin is 10 to 30% by mass and the content of the thermally conductive filler is 70 to 90% by mass based on 100% by mass of the total amount of the silicone resin and the thermally conductive filler. When the content of the thermally conductive filler is 70% by mass or more, the thermal conductivity of the heat dissipation sheet is improved, and sufficient heat dissipation performance can be easily obtained. Further, when the content of the thermally conductive filler is 90% by mass or less, it is possible to prevent voids from being easily generated at the time of forming of the heat dissipation sheet, and it is possible to increase the insulating property and mechanical strength of the heat dissipation sheet. In the case of a combination of aggregate particles and particles other than aggregate particles, the content of the aggregate particles in the thermally conductive filler may be 30% by mass or more, may be 40% by mass or more, may be 50% by mass or more, may be 60% by mass or more, or may be 70% by mass or more. In addition, substantially the aggregate particles may be present in an amount of 80% by mass or more or 90% by mass or more, or 100% by mass may be the aggregate particles. Moreover, the present invention is effective when aggregate particles having a relatively large particle diameter are applied, and the average particle diameter of the aggregate particles is 30 $\mu$m or more. As the particles other than the aggregate particles, non-aggregated metal oxide particles such as alumina and silica are preferable. The aggregate particles are aggregate particles of hexagonal boron nitride (h-BN), and the proportion of the aggregate particles of h-BN in the total amount of the thermally conductive filler is set to 90% by mass or more.

The composition for a heat dissipation sheet may contain components other than the silicone resin and the thermally conductive filler. The other components are, for example, additives and impurities. The content of the other components is, for example, 5% by mass or less with respect to the total amount 100% by mass of the silicone resin and the thermally conductive filler, and preferably 3% by mass or less, and more preferably 1% by mass or less.

Examples of the additive include a reinforcing agent, an extender, a thermal resistance improver, a flame retardant, an adhesion aid, a conductive agent, a surface treatment agent, and a pigment.

<Reinforcing Layer>

The heat dissipation sheet according to the first aspect of the present invention may include a reinforcing layer. The reinforcing layer plays a role of further improving the mechanical strength of the heat dissipation sheet, and further, when the heat dissipation sheet is compressed in the thickness direction, the reinforcing layer exerts an effect of suppressing the extension of the heat dissipation sheet in the plane direction and ensuring the insulating property. Examples of the reinforcing layer include glass cloth; resin films such as polyester, polyamide, polyimide, polycarbonate, and acrylic resin; fabric fiber mesh cloths such as cotton, hemp, aramid fiber, cellulose fiber, nylon fiber, and polyolefin fiber; nonwoven fabrics such as aramid fiber, cellulose fiber, nylon fiber, and polyolefin fiber; metal fiber mesh cloths such as stainless steel, copper, and aluminum; and metal foils such as copper, nickel, and aluminum. These may be used alone or in combination of two or more kinds thereof. Among these, glass cloth is preferable from the viewpoint of thermal conductivity and insulating property.

When a glass cloth is used as the reinforcing layer, a commercially available glass cloth having an opening can be used. The thickness of the glass cloth is preferably 10 $\mu$m to 150 $\mu$m. When the thickness of the glass cloth is 10 $\mu$m or more, the glass cloth can be prevented from being broken during handling. On the other hand, when the thickness of the glass cloth is 150 $\mu$m or less, it is possible to suppress the decrease in the thermal conductivity of the heat dissipation sheet due to the glass cloth. From such a viewpoint, the thickness of the glass cloth is more preferably 20 to 90 $\mu$m, and still more preferably 30 to 60 $\mu$m. Some commercially available glass cloths have a fiber diameter of 4 to 9 $\mu$m, and these glass cloths can be used for the heat dissipation sheet. The tensile strength of the glass cloth is, for example, 100 to 1000 N/25 mm. In addition, the length of one side of the opening of the glass cloth is preferably 0.1 to 1.0 mm from the viewpoint of achieving a balance between thermal conductivity and strength. An example of the glass cloth that can be used for the heat dissipation sheet is a trade name "H25 F104" manufactured by Unitika Ltd.

(Form of Heat Dissipation Sheet)

The form of the heat dissipation sheet according to the first aspect of the present invention is not particularly limited as long as the thickness thereof exceeds 10 $\mu$m. The upper limit of the thickness is also not particularly limited, but is preferably 500 $\mu$m or less. Further, it may be a sheet product or a roll product. It is more preferably 0.10 mm or more and 0.40 mm or less.

[Method for Producing Heat Dissipation Sheet of First Aspect]

The heat dissipation sheet according to the first aspect of the present invention containing a silicone resin and a thermally conductive filler can be produced by a production method including:

a composition preparing step of preparing a composition by mixing 10 to 30% by mass of the silicone resin and 70 to 90% by mass of the thermally conductive filler based on 100% by mass of the total amount of the silicone resin and the thermally conductive filler;
a sheet forming step of forming the composition into a sheet after the composition preparing step;
a preheating step of preheating the sheet at a preheating temperature lower than a curing starting temperature while pressurizing the sheet after the sheet forming step; and
a curing step of heating the preheated sheet at a temperature equal to or higher than the curing starting temperature while pressurizing the sheet after the preheating step.

In the heat dissipation sheet according to the first aspect of the present invention thus obtained, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I) $[(D + W)/2]$, the average value of an aspect ratio $[D/W]$ is in the range of 0.4 or more and 1.4 or less.

In order to sufficiently increase the insulating property, the relative density derived by a method of measuring the density by the Archimedes method and comparing the relative density with the theoretical density by calculation is preferably 88% or more, 90% or more, and 100% or less. Here, the theoretical density is calculated, for example, when the heat dissipation sheet contains boron nitride as a thermally conductive filler, silicone resin as a resin, and glass cloth, assuming that the density of the boron nitride is 2.2 $g/cm^3$, the density of the silicone resin is 0.98 $g/cm^3$, and the density of the glass cloth is 2.54 $g/cm^3$. In addition, after measuring the mass of the heat dissipation sheet, the silicone resin is removed from the heat dissipation sheet using a solvent, and the masses of the boron nitride and the glass cloth are measured, respectively. A value obtained by subtracting the masses of the boron nitride and the glass cloth from the mass of the heat dissipation sheet is the mass of the silicone resin. These density values and the measured mass values are used to calculate the theoretical density of the heat dissipation sheet.

(Composition Preparing Step)

In the composition preparing step, a silicone resin and a thermally conductive filler are mixed to prepare a composition for a heat dissipation sheet.

(Sheet Forming Step)

In the sheet forming step, the composition for a heat dissipation sheet is formed into a sheet shape to prepare a composition sheet for a heat dissipation sheet. For example, the composition for a heat dissipation sheet can be formed into a sheet shape by coating the composition for a heat dissipation sheet onto a film having releasability. The coating method is not particularly limited, and a known coating method such as a doctor blade method, a comma coater method, a screen printing method, or a roll coater method capable of uniform coating can be employed. However, the doctor blade method and the comma coater method are preferable from the viewpoint that the thickness of the coated composition for a heat dissipation sheet can be controlled with high accuracy. When the heat dissipation sheet includes a reinforcing layer, it is preferable that the composition for a heat dissipation sheet is coated after the reinforcing layer is placed on the film having releasability.

(Preheating Step)

In the preheating step, the composition sheet for a heat dissipation sheet is preheated at a preheating temperature lower than a curing starting temperature while the composition sheet for a heat dissipation sheet is pressurized. Since the composition sheet for a heat dissipation sheet is not cured at the preheating temperature, bubbles and voids that cause dielectric breakdown of the heat dissipation sheet are sufficiently removed by this step, and insulation failure of the heat dissipation sheet caused by burrs of the heat-dissipating component or by foreign matter mixed between the heat-generating electronic component and the heat dissipation sheet or between the heat-dissipating component and the heat dissipation sheet can be suppressed. The curing starting temperature is a temperature at which the composition sheet for a heat dissipation sheet starts curing. It means a temperature at which an exothermic peak rises in differential scanning calorimetry (DSC). Therefore, the composition sheet for a heat dissipation sheet does not start curing at a temperature lower than the curing starting temperature.

When the thermally conductive filler is an aggregate particle, the aggregate particle is loosened by this step to form a primary particle aggregate in which the primary particles are aggregated in a lump by a weak interaction force between particles. The current flows in the heat dissipation sheet through the resin filling the voids in the primary particle aggregate, and as a result, flows through a complicated path. As a result, insulation failure is less likely to occur in the heat dissipation sheet, and it is possible to suppress insulation failure of the heat dissipation sheet caused by burrs of the heat-dissipating component or by foreign matter mixed between the heat-generating electronic component and the heat dissipation sheet or between the heat-dissipating component and the heat dissipation sheet.

The pressure at which the composition sheet for a heat dissipation sheet is pressurized in the preheating step is $4.9*10^6$ to $1.96*10^7$ Pa (50 to 200kgf/cm$^2$) . When the composition sheet for a heat dissipation sheet is pressurized at $4.9*10^6$ Pa (50 kgf / cm$^2$) or more, bubbles in the resin can be more sufficiently removed to increase the density of the heat dissipation sheet, thereby improving the insulating property of the heat dissipation sheet. Further, when the composition sheet for a heat dissipation sheet is pressurized to $1.96*10^7$ Pa (200kgf /cm$^2$) or less, the heat dissipation sheet can be produced more efficiently, and the production cost can be reduced.

In addition, when the thermally conductive filler is aggregate particles, the aggregate particles can be loosened while appropriately maintaining the shape of the aggregate particles, and thus insulation failure can be suppressed without reducing thermal conductivity. From such a viewpoint, the pressure at which the composition sheet for a heat dissipation sheet is pressurized is more preferably $6.9*10^6$ to $1.47*10^7$ Pa (70 to 150 kgf/cm$^2$) .

The preheating temperature is 50 to 80°C. By setting the preheating temperature to 50°C or higher, it is possible to suppress a decrease in the thermal conductivity of the heat dissipation sheet caused by orientation of particles due to excessive collapse of aggregation of aggregate particles aggregated in a lump form in the composition sheet for a heat dissipation sheet. In addition, by setting the heating temperature to 80°C or lower, it is possible to sufficiently remove bubbles in the resin without curing the resin, to increase the density of the heat dissipation sheet, and to improve the insulating property of the heat dissipation sheet. From such a viewpoint, the preheating temperature is more preferably 55 to 75°C.

The heating time for preheating the composition sheet for a heat dissipation sheet at the preheating temperature is preferably 5 to 10 minutes. By setting the heating time to 5 minutes or more, it is possible to more sufficiently remove bubbles in the resin, to increase the density of the heat dissipation sheet, and to improve the insulating property of the heat dissipation sheet. Further, by setting the heating time to 10 minutes or less, the productivity of the heat dissipation sheet can be improved, and the production cost can be reduced. From such a viewpoint, the heating time is more preferably 6 to 9 minutes.

By adjusting the pressurizing pressure, the preheating temperature, and the heating time in the preheating step to the above-described ranges, the aggregate particles are moderately loosened, and deformed, or oriented, and thus it becomes easy to adjust the average value of the aspect ratio represented by the formula (II) to be in the range of 0.4 or more and 1.4 or less with respect to the 1st to 24th particles from the largest of biaxial average diameters represented by the formula (I). However, in the case of using deformable particles such as aggregate particles, specific conditions to be set are appropriately determined according to the strength of the aggregate particles, the type of the resin, and the like. For example, in the case of aggregate particles having weak strength, it is necessary to set the pressurizing pressure to be weak. The aspect ratio can be adjusted by determining the aggregate particles to be used, forming the heat dissipation sheet once, confirming the average value of the aspect ratio, and setting a slightly weak pressurizing pressure when the heat dissipation sheet is excessively crushed. Regarding the heating temperature and the heating time, the conditions are similarly set in consideration of the relationship with the ease of collapse of the aggregate particles, the ease of filling with the resin (ease of removing bubbles), and the like. Since suitable conditions can be set only by observing the cross section of the heat dissipation sheet, the conditions of the preheating step can be set to conditions suitable for efficiently obtaining a heat dissipation sheet having a high dielectric breakdown voltage and good thermal resistance even when the fastening pressure is increased to about 1.0 MPa, as compared with the case where the conditions are set by measuring the dielectric breakdown voltage and thermal resistance of the heat dissipation sheet.

(Curing Step)

In the curing step, the preheated composition sheet for a heat dissipation sheet is heated at a temperature equal to or higher than the curing starting temperature while being pressurized. As a result, the composition sheet for a heat dissipation sheet is cured to form a heat dissipation sheet.

The pressure at which the composition sheet for a heat dissipation sheet is pressurized in the curing step is $9.8*10^6$ to $1.96*10^7$ Pa (100 to 200kgf/cm$^2$), When the composition sheet for a heat dissipation sheet is pressurized at

$9.8*10^6$ Pa (100 kgf/ cm$^2$) or more, bubbles in the resins are further removed to increase the density of the heat dissipation sheet, thereby further improving the insulating property of the heat dissipation sheet. In addition, when the heat dissipation sheet has a reinforcing layer, it is possible to improve the bonding property between the resin and the reinforcing layer. Further, when the composition sheet for a heat dissipation sheet is pressurized to $1.96*10^7$ Pa (200kgf/cm$^2$) or less, the productivity of the heat dissipation sheet can be improved, and the production cost can be reduced. From such a viewpoint, the pressure at which the composition sheet for a heat dissipation sheet is pressurized is more preferably $1.3*10^7$ to $1.77*10^7$ Pa (130 to 180 kgf/cm$^2$) Further, as described above, in the present invention, in order to reduce the amount of voids in the heat dissipation sheet by gradually heating and pressurizing, the pressurizing force in the curing step is larger than the pressurizing force in the preheating.

In the curing step, the temperature at which the preheated composition sheet for a heat dissipation sheet is heated is 130 to 200°C. By setting the heating temperature of the composition sheet for a heat dissipation sheet to 130°C or higher, the composition sheet for a heat dissipation sheet can be further sufficiently cured. In addition, by setting the heating temperature of the composition sheet for a heat dissipation sheet to 200°C or lower, the productivity of the heat dissipation sheet can be improved, and the production cost can be reduced. From such a viewpoint, the heating temperature of the composition sheet for a heat dissipation sheet is more preferably 140 to 180°C.

The heating time for heating the composition sheet for a heat dissipation sheet in the curing step is preferably 10 to 60 minutes. By setting the heating time to 10 minutes or more, the composition sheet for a heat dissipation sheet can be further sufficiently cured. Further, by setting the heating time to 60 minutes or less, the productivity of the heat dissipation sheet can be improved, and the production cost can be reduced.

(Low Molecular Weight Siloxane Removal Step)

The method for producing a heat dissipation sheet according to the first aspect of the present invention preferably further includes a low molecular weight siloxane removal step of heating the composition sheet for a heat dissipation sheet heated at a temperature equal to or higher than the curing starting temperature at a heating temperature of 130 to 200°C for 2 to 30 hours. This makes it possible to remove low molecular weight siloxanes from the resin. When the concentration of the low molecular weight siloxane in the resin is high, siloxane gas is generated, and an insulating film of silicon oxide may be formed on the electric contact by energy due to sliding or sparking of the electric contact, which may cause contact failure. The amount of low molecular weight siloxane in the heat dissipation sheet is preferably 50 ppm or less.

By setting the heating temperature to 130°C or higher, the low molecular weight siloxane in the resin can be sufficiently removed. By setting the heating temperature to 200°C or lower, flexibility of the heat dissipation sheet can be ensured. Further, the productivity of the heat dissipation sheet can be improved, and the production cost can be reduced. From such a viewpoint, the heating temperature is more preferably 140 to 190°C.

By setting the heating time to 2 hours or more, the low molecular weight siloxane in the resin can be sufficiently removed. By setting the heating time to 30 hours or less, the productivity of the heat dissipation sheet can be improved, and the production cost can be reduced. From such a viewpoint, the heating time is more preferably 3 to 10 hours.

[Internal Structure of Heat Dissipation Sheet of First Aspect]

In the heat dissipation sheet according to the first aspect of the present invention, in a cross-sectional view cut in the thickness direction from one surface to the other surface, the cross-sectional shape of the thermally conductive filler is imaged with a scanning electron microscope (SEM), and the obtained SEM image is subjected to image analysis to observe the particles of the specific thermally conductive filler dispersed in the silicone resin.

Since the heat dissipation sheet transfers heat from one surface of the sheet in contact with the heat-generating electronic component to the other surface in contact with the heat sink or the like, an observation region is set in image analysis so as to include all heat transfer paths from one surface to the other surface of the sheet. In addition, the observation region contains 24 particles having an average particle diameter of 15 μm or more per 0.3 mm of the thickness of the heat dissipation sheet among the thermally conductive fillers dispersed in the silicone resin, and the average value of the aspect ratio is calculated in the observation region containing the 24 particles. The calculation result may be in the range of 0.4 or more and 1.4 or less. Here, the average value of the aspect ratio is an average of arbitrary five visual fields.

Specifically, for example, the observation region may be defined as follows. A range in which the cross section of the heat dissipation sheet is imaged in an image obtained by imaging at the maximum magnification among magnifications when one image obtained by imaging the heat dissipation sheet with the SEM includes both one surface and the other surface of the heat dissipation sheet is defined as an observation region. Since the image is taken at the maximum magnification, the largest image of the thermally conductive filler can be taken among the images including both the one surface and the other surface of the heat dissipation sheet. Since the number of thermally conductive filler particles included in the observation region varies depending on the aspect ratio of the image, the aspect ratio of the image is set to be the same as the aspect ratio of the image captured by a scanning electron microscope (SEM) (manufactured by Hitachi High-Tech Corporation, trade name: SU6600 type).

In the above image, when the number of thermally conductive filler particles included in the image is less than 24, for example, an imaged range of a cross section of the heat dissipation sheet in an image obtained by imaging at the maximum magnification among magnifications when one image obtained by imaging the heat dissipation sheet with the SEM includes 24 thermally conductive filler particles is set as the observation region.

The reason why the 1st to 24th particles from the largest of biaxial average diameters are used is that among the thermally conductive filler particles contained in the heat dissipation sheet, thermally conductive filler particles having a large size have a large influence on the dielectric breakdown voltage and the thermal resistance at the time of fastening, and it is considered that the dielectric breakdown voltage and the thermal resistance at the time of fastening in the heat dissipation sheet can be evaluated with sufficient accuracy by evaluating 24 thermally conductive filler particles from the largest size. Although more than 24 thermally conductive filler particles may be evaluated, the accuracy of the evaluation is not so high as compared with the case where 24 thermally conductive filler particles are evaluated.

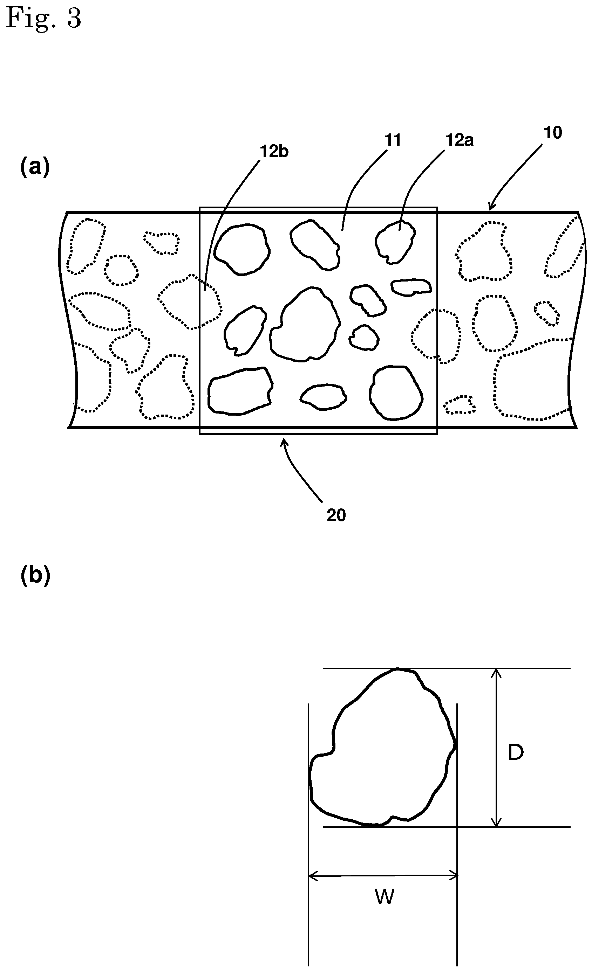

The particle observation method according to the first aspect of the present invention will be described in more detail with reference to Fig. 3.

Among the particles of the thermally conductive filler, those completely included in the observation region are set as observation targets. That is, when a part of the particle is outside the observation region, the particle is excluded (Fig. 3a).

The particle has a complicated and irregular shape, and the particle diameter cannot be simply and quantitatively expressed from the cross-sectional shape. Therefore, various equivalent diameters such as Feret diameter, Martin diameter, and Heywood diameter have been defined. In the first aspect of the present invention, the particle diameter is defined using the Feret diameter. The Feret diameter corresponds to the interval between two parallel lines when the particle is sandwiched between two parallel lines in a specified direction so as to be in contact with a part of the particle.

For the particles to be observation targets, the Feret diameter in the thickness direction is measured and represented by D, and the Feret diameter in the plane direction is measured and represented by W (Fig. 3b).

The Feret diameter (D) in the thickness direction and the Feret diameter (W) in the plane direction are measured for all particles to be observation targets, and the biaxial average diameter represented by the formula (I) and the aspect ratio represented by the formula (II) are calculated.

$$(D + W)/2 \qquad (I)$$

$$D/W \qquad (II)$$

All the particles to be observation targets are ranked by the biaxial average diameter, and the average value of the aspect ratio is calculated for the 1st to 24th largest particles.

The heat dissipation sheet according to the first aspect of the present invention is characterized in that the average value of the aspect ratio of the particles is in the range of 0.4 or more and 1.4 or less. When the average value of the aspect ratio is within this range, the heat dissipation sheet has a high dielectric breakdown voltage and exhibits good thermal resistance even when the fastening pressure is increased up to about 1.0 MPa, thereby exhibiting excellent characteristics even when used in in-vehicle applications.

Specifically, the observation region is set so as to include 24 particles of the thermally conductive filler dispersed in the silicone resin. When the observation region is set in this manner and the average value of the aspect ratio of 24 particles is 0.4 or more and 1.4 or less, since boron nitride is oriented in the plane direction to some extent, it is possible to lengthen the dielectric breakdown path by boron nitride having high insulating property and to express a high dielectric breakdown voltage, and since boron nitride is sufficiently oriented also in the thickness direction, a state in which thermal conductivity is high can be maintained.

2. Second Aspect

[Heat Dissipation Sheet of Second Aspect]

The heat dissipation sheet according to a second aspect of the present invention will be described below. The heat dissipation sheet according to the second aspect of the present invention will be described mainly with respect to points different from the heat dissipation sheet according to the first aspect of the present invention, and description of points similar to the heat dissipation sheet according to the first aspect of the present invention will be omitted.

The heat dissipation sheet according to the second aspect of the present invention is a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I), an area ratio (Sr) of a total area S of cross-sectional shapes of a plurality of the particles to a whole area of the cross-sectional view is in a range of 20% or more and 80% or less.

$$(D + W)/2 \qquad (I)$$

(Constituents of Heat Dissipation Sheet of Second Aspect)

Since the constituents of the heat dissipation sheet according to the second aspect of the present invention are the same as those of the heat dissipation sheet according to the first aspect of the present invention, the description of the constituents of the heat dissipation sheet according to the second aspect of the present invention is omitted.

(Form of Heat Dissipation Sheet of Second Aspect)

Since the form of the heat dissipation sheet according to the second aspect of the present invention is the same as the form of the heat dissipation sheet according to the first aspect of the present invention, the description of the form of the heat dissipation sheet according to the second aspect of the present invention is omitted.

[Method for Producing Heat Dissipation Sheet of Second Aspect]

In the heat dissipation sheet according to the second aspect of the present invention obtained by the method for producing a heat dissipation sheet according to the second aspect of the present invention, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I) [(D + W)/2], an area ratio (Sr) of a total area S of cross-sectional shapes of a plurality of the particles to a whole area of the cross-sectional view is in a range of 20% or more and 80% or less. The preheating step was modified as follows. Except for this point, the method for producing the heat dissipation sheet according to the second aspect of the present invention is the same as the method for producing the heat dissipation sheet according to the first aspect of the present invention, and therefore the description of the method for producing the heat dissipation sheet according to the second aspect of the present invention is omitted.

(Preheating Step)

The preferable ranges of the pressurizing pressure, the preheating temperature, and the heating time in the preheating step are the same, but unlike the first aspect, specific conditions are determined according to the strength of the particles to be used, the type of the resin, and the like so that the area ratio (Sr) is in the range of 20% or more and 80% or less. For example, in the case of aggregate particles having weak strength, it is necessary to set the pressurizing pressure to be weak. The area ratio (Sr) can be adjusted by determining the aggregate particles to be used, forming the heat dissipation sheet once, confirming the area ratio (Sr), and setting a slightly weak pressurizing pressure when the heat dissipation sheet is excessively crushed and the area ratio (Sr) is excessively small. As described above, the conditions of the heating temperature and the heating time are also set in consideration of the relationship with the ease of collapse of the aggregate particles, the ease of filling with the resin (ease of reducing bubbles), and the like. Since suitable conditions can be set only by observing the cross section of the heat dissipation sheet, the conditions of the preheating step can be set to conditions suitable for efficiently obtaining a heat dissipation sheet having a high dielectric breakdown voltage and good thermal resistance even when the fastening pressure is increased to about 1.0 MPa, as compared with the case where the conditions are set by measuring the dielectric breakdown voltage and thermal resistance of the heat dissipation sheet.

[Internal Structure of Heat Dissipation Sheet of Second Aspect]

The internal structure of the heat dissipation sheet according to the second aspect of the present invention will be described below. The internal structure of the heat dissipation sheet according to the second aspect of the present invention will be described mainly with respect to points different from the internal structure of the heat dissipation sheet according to the first aspect of the present invention, and description of points similar to the internal structure of the heat dissipation sheet according to the first aspect of the present invention will be omitted.

The area ratio is calculated in the observation region containing the 24 particles. In the second aspect of the present invention, the calculation result is in the range of 20% or more and 80% or less. Here, the area ratio is an average of arbitrary five visual fields.

The Feret diameter (D) in the thickness direction and the Feret diameter (W) in the plane direction are measured for all the particles to be observation targets, and the biaxial average diameter represented by formula (I) and the area ratio of the total area S of the cross-sectional shapes of a plurality of the particles to the whole area of the observation region are calculated.

$$(D + W)/2 \qquad (I)$$

The heat dissipation sheet according to the second aspect of the present invention is characterized in that an area ratio (Sr) of a total area S of cross-sectional shapes of a plurality of the particles to a whole area of the cross-sectional view of the observation region is in a range of 20% or more and 80% or less. When the area ratio is within this range, the heat dissipation sheet has a high dielectric breakdown voltage and exhibits good thermal resistance even when the fastening pressure is increased up to about 1.0 MPa, thereby exhibiting excellent characteristics even when used in in-vehicle applications.

Specifically, the observation region is set so as to include 24 particles of the thermally conductive filler dispersed in the silicone resin. By setting the observation region in this manner and setting the area ratio of the 24 particles to the whole to 20% or more and 80% or less, an effect of increasing thermal conductivity can be obtained because the ratio of large particles increases and the contact thermal resistance between particles can be reduced, and an effect of also providing high insulating property can be obtained because high thermal conductivity can be exhibited while the filling rate of particles is low and defects in the resin composition portion are less likely to occur.

3. Third Aspect

[Heat Dissipation Sheet of Third Aspect]

The heat dissipation sheet according to a third aspect of the present invention will be described below. The heat dissipation sheet according to the third aspect of the present invention will be described mainly with respect to points different from the heat dissipation sheet according to the first aspect of the present invention, and description of points similar to the heat dissipation sheet according to the first aspect of the present invention will be omitted.

The heat dissipation sheet according to the third aspect of the present invention is a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I), a particle number ratio, $n_w/n_d$, of a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, is in a range of 0.4 or more and less than 1.

$$(D + W)/2 \qquad (I)$$

(Constituents of Heat Dissipation Sheet of Third Aspect)

Since the constituents of the heat dissipation sheet according to the third aspect of the present invention are the same as those of the heat dissipation sheet according to the first aspect of the present invention, the description of the constituents of the heat dissipation sheet according to the third aspect of the present invention is omitted.

(Form of Heat Dissipation Sheet of Third Aspect)

Since the form of the heat dissipation sheet according to the third aspect of the present invention is the same as the form of the heat dissipation sheet according to the first aspect of the present invention, the description of the form of the heat dissipation sheet according to the third aspect of the present invention is omitted.

[Method for Producing Heat Dissipation Sheet of Third Aspect]

In the heat dissipation sheet according to the third aspect of the present invention obtained by the method for producing a heat dissipation sheet according to the third aspect of the present invention, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I) [(D + W)/2], an average value of a particle number ratio $[n_w/n_d]$ is in the range of 0.4 or more and less than 1. The preheating step was modified as follows. Except for this point, the method for producing the heat dissipation sheet according to the third aspect of the present invention is the same as the method for producing the heat dissipation sheet according to the first aspect of the present invention, and therefore the description of the method for producing the heat dissipation sheet according to the third aspect of the present invention is omitted.

(Preheating Step)

The preferable ranges of the pressurizing pressure, the preheating temperature, and the heating time in the preheating step are the same, but unlike the first aspect, specific conditions are determined according to the strength of the particles used, the type of the resin, and the like so that an average value of the particle number ratio $[n_w/n_d]$ is in the range of 0.4 or more and less than 1. For example, in the case of aggregate particles having weak strength, it is necessary to set the pressurizing pressure to be weak. The particle number ratio $[n_w/n_d]$ can be adjusted by determining the aggregate particles to be used, forming the heat dissipation sheet once, confirming the particle number ratio $[n_w/n_d]$, and setting a slightly weak pressurizing pressure when the heat dissipation sheet is excessively crushed and the particle number ratio $[n_w/n_d]$ is excessively small. As described above, the conditions of the heating temperature and the heating time are also set in consideration of the relationship with the ease of collapse of the aggregate particles, the ease of filling with the resin (ease of reducing bubbles), and the like. Since suitable conditions can be set only by observing the cross section of the heat dissipation sheet, the conditions of the preheating step can be set to conditions suitable for efficiently obtaining a heat dissipation sheet having a high dielectric breakdown voltage and good thermal resistance even when the fastening pressure is increased to about 1.0 MPa, as compared with the case where the conditions are set by measuring the dielectric breakdown voltage and thermal resistance of the heat dissipation sheet.

[Internal Structure of Heat Dissipation Sheet of Third Aspect]

The internal structure of the heat dissipation sheet according to the third aspect of the present invention will be described below. The internal structure of the heat dissipation sheet according to the third aspect of the present invention will be described mainly with respect to points different from the internal structure of the heat dissipation sheet according to the first aspect of the present invention, and description of points similar to the internal structure of the heat dissipation sheet according to the first aspect of the present invention will be omitted.

The particle number ratio $[n_w/n_d]$ is calculated in the observation region containing the 24 particles. The calculation result may be in the range of 0.4 or more and less than 1. Here, the particle number ratio is an average of arbitrary five visual fields.

The Feret diameter (D) in the thickness direction and the Feret diameter (W) in the plane direction are measured for all particles to be observation targets, and the biaxial average diameter represented by the formula (I),

$$(D + W)/2 \qquad (I)$$

and a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, are calculated.

Multiple straight lines may traverse a single particle, but they are counted in duplicate. The number of transverse particles per unit length represents the probability of existence of a thermally conductive region.

Next, using the obtained $n_w$ and $n_d$, the particle number ratio $n_w/n_d$ is calculated.

All particles to be observation targets are ranked based on the biaxial average diameter, and the particle number ratio is calculated for the 1st to 24th particles from the largest of biaxial average diameters.

The heat dissipation sheet according to the third aspect of the present invention is characterized in that the particle number ratio is in the range of 0.4 or more and less than 1. When the particle number ratio is within this range, the heat dissipation sheet has a high dielectric breakdown voltage and has good thermal resistance even when the fastening pressure is increased up to about 1.0 MPa, thereby exhibiting excellent characteristics even when used in in-vehicle applications.

Specifically, the observation region is set so as to include 24 particles of the thermally conductive filler dispersed in the silicone resin. When the observation region is set in this manner and the particle number ratio of the 24 particles is in the range of 0.4 or more and less than 1, the particles are deformed so as to spread in the plane direction to the extent that the particles are not crushed. This increases the probability of existence of particles in the thickness direction. This increase reduces the distance between particles in the thickness direction and increases the apparent contact area between particles in the thickness direction, thereby improving the heat dissipation characteristics. In addition, it is considered that the insulating property can also be improved because the presence of a large number of boron nitride particles having a high insulating property in the plane direction can significantly reduce the presence of defects in a resin layer or an air layer having a low insulating layer.

4. Fourth Aspect

[Heat Dissipation Sheet of Fourth Aspect] (not falling under the protection scope of the present invention)

The heat dissipation sheet according to a fourth aspect of the present invention will be described below. The heat dissipation sheet according to the fourth aspect of the present invention will be described mainly with respect to points different from the heat dissipation sheet according to the first aspect of the present invention, and description of points similar to the heat dissipation sheet according to the first aspect of the present invention will be omitted.

The heat dissipation sheet according to the fourth aspect of the present invention contains a silicone resin and a thermally conductive filler, wherein the content of the silicone resin is 10 to 40% by mass and the content of the thermally conductive filler is 60 to 90% by mass based on 100% by mass of the total amount of the silicone resin and the thermally conductive filler, and the thermally conductive filler is selected from among metal oxides such as alumina, silica, and titanium dioxide; nitrides such as aluminum nitride, boron nitride, and silicon nitride; silicon carbide; and aluminum hydroxide.

(Constituents of Heat Dissipation Sheet of Fourth Aspect)

In the thickness direction, when a thermal resistance value when a pressure of 0.4 MPa was applied is defined as $R_{0.4}$, and when a thermal resistance value when a pressure of 1.0 MPa was applied is defined as $R_{1.0}$, a thermal resistance ratio $R_{0.4}/R_{1.0}$ is 1 or more.

When a thermal resistance value when a pressure of 1.0 MPa was applied is defined as $R_{1.0}$ in the thickness direction, the $R_{1.0}$ is preferably 1.30°C/W or more.

Otherwise, since the constituents of the heat dissipation sheet according to the fourth aspect of the present invention are the same as those of the heat dissipation sheet according to the first aspect of the present invention, the description of the constituents of the heat dissipation sheet according to the fourth aspect of the present invention is omitted.

(Form of Heat Dissipation Sheet of Fourth Aspect)

Since the form of the heat dissipation sheet according to the fourth aspect of the present invention is the same as the form of the heat dissipation sheet according to the first aspect of the present invention, the description of the form of the heat dissipation sheet according to the fourth aspect of the present invention is omitted.

[Method for Producing Heat Dissipation Sheet of Fourth Aspect] (not falling under the protection scope of the present invention)

In the composition preparing step, a silicone resin and a thermally conductive filler are mixed to prepare a composition for a heat dissipation sheet. As the thermally conductive filler to be used in the heat dissipation sheet according to the fourth aspect of the present invention, a substance having a thermal conductivity exceeding 10 W/m K is preferable, and examples thereof include metal oxides such as alumina, silica, and titanium dioxide; nitrides such as aluminum nitride, boron nitride, and silicon nitride; silicon carbide; and aluminum hydroxide, which can be used alone or in combination of several kinds thereof. In particular, it is preferable to include aggregate particles formed by aggregating primary particles of hexagonal boron nitride (h-BN).

In the method for producing the heat dissipation sheet according to the fourth aspect of the present invention, by providing a preheating step and gradually heating and pressurizing to moderately loosen the aggregate particles and to deform or orient the aggregate particles, the thermal resistance ratio $R_{0.4}/R_{1.0}$ is adjusted to 1 or more.

As described above, unlike the first aspect, specific conditions are determined so that the above thermal resistance ratio $R_{0.4}/R_{1.0}$ is 1 or more depending on the strength of the particles to be used, the type of resin, and the like. For example, in the case of aggregate particles having weak strength, it is necessary to set the pressurizing pressure to be weak. The thermal resistance ratio $R_{0.4}/R_{1.0}$ can be adjusted by determining the aggregate particles to be used, forming the heat dissipation sheet once, confirming the thermal resistance ratio $R_{0.4}/R_{1.0}$, and setting a slightly weak pressurizing pressure when the heat dissipation sheet is excessively crushed and the thermal resistance ratio $R_{0.4}/R_{1.0}$ is excessively small. As described above, the conditions of the heating temperature and the heating time are also set in consideration of the relationship with the ease of collapse of the aggregate particles, the ease of filling with the resin (ease of reducing bubbles), and the like.

When pressure is applied to the heat dissipation sheet and the aggregate particles are moderately loosened, the thermal resistance decreases, so that the thermal resistance ratio $R_{0.4}/R_{1.0}$ becomes 1 or more, but if it is less than 1, it is suggested that the aggregate particles are not loosened. It was found that the aggregate particles were easy to loosen under conditions of lower temperature and higher pressure.

Therefore, in the preheating step, when the thermal resistance ratio is 1 or more, conditions are set such that the thermal resistance ratio is less than 1 by lowering the temperature or increasing the pressure.

Except for the above, the method for producing the heat dissipation sheet according to the fourth aspect of the present invention is the same as the method for producing the heat dissipation sheet according to the first aspect of the present invention, and therefore the description of the method for producing the heat dissipation sheet according to the fourth aspect of the present invention is omitted.

[Internal Structure of Heat Dissipation Sheet of Fourth Aspect]

The internal structure of the heat dissipation sheet according to the fourth aspect of the present invention will be described below. The internal structure of the heat dissipation sheet according to the fourth aspect of the present invention will be described mainly with respect to points different from the internal structure of the heat dissipation sheet according to the first aspect of the present invention, and description of points similar to the internal structure of the heat dissipation sheet according to the first aspect of the present invention will be omitted.

Since the heat dissipation sheet transfers heat from one surface of the sheet in contact with a heat-generating electronic component toward the other surface in contact with a heat sink or the like, during image analysis, the observation region is set so as to include all heat transfer paths from one surface to the other surface of the sheet, and the distribution of the thermally conductive filler particles, particularly the distribution in the thickness direction, is confirmed.

[Combination of First to Fourth Aspects]

Among the first to fourth aspects of the present invention, two or more aspects can be combined.

For example, by combining the first aspect and the second aspect, the heat dissipation sheet of the present invention may be a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I), the average value of an aspect ratio represented by formula (II) is in a range of 0.4 or more and 1.4 or less, and an area ratio (Sr) of a total area S of cross-sectional shapes of a plurality of the particles to a whole area of the cross-sectional view is in a range of 20% or more and 80% or less.

$$(D + W)/2 \qquad (I)$$

$$D/W \qquad (II)$$

In addition, by combining the first aspect and the third aspect, the heat dissipation sheet of the present invention may be a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I), the average value of an aspect ratio represented by formula (II) is in a range of 0.4 or more and 1.4 or less, and a particle number ratio, $n_w/n_d$, of a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, is in a range of 0.4 or more and less than 1.

$$(D + W)/2 \qquad (I)$$

$$D/W \qquad (II)$$

In addition, by combining the first aspect and the fourth aspect, the heat dissipation sheet of the present invention may be a heat dissipation sheet containing a silicone resin and a thermally conductive filler, wherein the content of the silicone resin is 10 to 40% by mass and the content of the thermally conductive filler is 60 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I), the average value of an aspect ratio represented by formula (II) is in a range of 0.4 or more and 1.4 or less,

$$(D + W)/2 \qquad (I)$$

$$D/W \qquad (II)$$

wherein in the resin composition, the content of the silicone resin is 10 to 40% by mass and the content of the thermally conductive filler is 60 to 90% by mass based on 100% by mass of the total amount of the silicone resin and the thermally conductive filler, and the thermally conductive filler is aggregate particles obtained by aggregating primary particles of hexagonal boron nitride, and wherein the heat dissipation sheet has a thermal resistance ratio $R_{0.4}/R_{1.0}$ of 1 or more, wherein $R_{0.4}$ is a thermal resistance value when a pressure of 0.4 MPa is applied in the thickness direction and $R_{1.0}$ is a thermal resistance value when a pressure of 1.0 MPa is applied in the thickness direction, and has an insulation resistance of 5.0 kV or more.

In addition, by combining the second aspect and the third aspect, the heat dissipation sheet of the present invention may be a heat dissipation sheet containing a silicone resin and a thermally conductive filler, wherein the content of the silicone resin is 10 to 30% by mass and the content of the thermally conductive filler is 70 to 90% by mass based on 100% by mass of the total amount of the silicone resin and the thermally conductive filler, wherein in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I),

$$(D + W)/2 \qquad (I)$$

an area ratio (Sr) of a total area S of cross-sectional shapes of a plurality of the particles to a whole area of the cross-sectional view may be in a range of 20% or more and 80% or less, and a particle number ratio, $n_w/n_d$, of a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, is in a range of 0.4 or more and less than 1.

In addition, by combining the second aspect and the fourth aspect, the heat dissipation sheet of the present invention may be a heat dissipation sheet containing a resin composition for a heat dissipation sheet containing a silicone resin and a thermally conductive filler, wherein the content of the silicone resin is 10 to 40% by mass and the content of the thermally conductive filler is 60 to 90% by mass based on 100% by mass of the total amount of the silicone resin and the thermally conductive filler, wherein in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I),

$$(D + W)/2 \qquad (I)$$

an area ratio (Sr) of a total area S of cross-sectional shapes of a plurality of the particles to a whole area of the cross-sectional view is in a range of 20% or more and 80% or less, and wherein in the resin composition, the content of the silicone resin is 10 to 40% by mass and the content of the thermally conductive filler is 60 to 90% by mass based on 100% by mass of the total amount of the silicone resin and the thermally conductive filler, and the thermally conductive filler is aggregate particles obtained by aggregating primary particles of hexagonal boron nitride, and wherein the heat dissipation sheet has a thermal resistance ratio $R_{0.4}/R_{1.0}$ of 1 or more, wherein $R_{0.4}$ is a thermal resistance value when a pressure of 0.4 MPa is applied in the thickness direction and $R_{1.0}$ is a thermal resistance value when a pressure of 1.0 MPa is applied in the thickness direction, and has an insulation resistance of 5.0 kV or more.

In addition, by combining the third aspect and the fourth aspect, the heat dissipation sheet of the present invention may be a heat dissipation sheet containing a silicone resin and a thermally conductive filler, wherein the content of the silicone resin is 10 to 40% by mass and the content of the thermally conductive filler is 60 to 90% by mass based on 100% by mass of the total amount of the silicone resin and the thermally conductive filler, wherein in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I),

$$(D + W)/2 \qquad (I)$$

a particle number ratio, $n_w/n_d$, of a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, is in a range of 0.4 or more and less than 1, wherein in the resin composition, the content of the silicone resin is 10 to 40% by mass and the content of the thermally conductive filler is 60 to 90% by mass based on 100% by mass of the total amount of the silicone resin and the thermally conductive filler, and the thermally conductive filler is aggregate particles obtained by aggregating primary particles of hexagonal boron nitride, and wherein the heat dissipation sheet has a thermal resistance ratio $R_{0.4}/R_{1.0}$ of 1 or more, wherein $R_{0.4}$ is a thermal resistance value when a pressure of 0.4 MPa is applied in the thickness direction and $R_{1.0}$ is a thermal resistance value when a pressure of 1.0 MPa is applied in the thickness direction, and has an insulation resistance of 5.0 kV or more.

Furthermore, the first to third aspects may be combined, the first, second and fourth aspects may be combined, the first, third and fourth aspects may be combined, the second, third and fourth aspects may be combined, and the first to fourth aspects may be combined.

Examples

1. First Embodiment

[Example 1] (not falling under the protection scope of the present disclosure)

(Preparation of Composition for Heat Dissipation Sheet)

After adding 70 g of aggregate particles of hexagonal boron nitride (crushing strength: 1 MPa, particle particle size: 20 $\mu$m) to 15 g of a silicone resin (manufactured by Wacker Asahikasei Silicone Co., Ltd., Model No.: LR3303-20A) and 15g of a silicone resin (manufactured by Wacker Asahikasei Silicone Co., Ltd., Model No.: LR3303-20B), toluene was added as a viscosity modifier so that the solid concentration was 70% by weight, and the mixture was mixed for 15 hours with a stirrer (trade name: HEIDON Three-One Motor, manufactured by SHINTO Scientific Co., Ltd.) equipped with a turbine type stirring blade to prepare a composition for a heat dissipation sheet. The mix proportion of the composition is shown in Table 1.

(Production of Heat Dissipation Sheet)

After a glass cloth (trade name: H25F 104, manufactured by Unitika Ltd.) was arranged on a Teflon (registered trademark) sheet, the above composition for a heat dissipation sheet was coated on the glass cloth with a comma coater to a thickness of 0.2 mm, and dried at 75°C for 5 minutes. Next, the dried composition for a heat dissipation sheet was turned upside down so that the glass cloth was on the upper side, coated onto the glass cloth with a comma coater to a thickness of 0.2 mm, and dried at 75°C for 5 minutes to prepare a sheet of the composition for a heat dissipation sheet in which the composition for a heat dissipation sheet was coated on both surfaces of the glass cloth. Thereafter, pressing was performed for 15 minutes under conditions of a preheating temperature of 70°C and a pressure of 120 kgf/cm² using a flat plate press machine (manufactured by Yanase Seisakusho Co., Ltd.) (preheating and pressurizing step). Thereafter, the temperature was raised to 150°C at a heating rate of 10°C/min while performing pressing of a pressure of 150 kgf/cm². Then, pressing was performed for 45 minutes under the conditions of a heating temperature (a temperature equal to or higher than the curing starting temperature) of 150°C and a pressure of 150 kgf/cm² to prepare a heat dissipation sheet having a thickness of 0.30 mm. Subsequently, the resultant was heated at a temperature of 150°C for 4 hours under normal pressure to remove the low molecular weight siloxane, thereby producing a heat dissipation sheet. The content of the thermally conductive filler was 70% by mass with respect to 100% by mass in total of the silicone resin and the thermally conductive filler in the heat dissipation sheet.

(Internal Structure of Heat Dissipation Sheet)

The heat dissipation sheet was cut perpendicularly to the surface, and a reflection electronic image of the cut surface was imaged using a scanning electron microscope (SEM) (manufactured by Hitachi High-Tech Corporation, trade name: SU6600 type). The image data was transferred to a personal computer manufactured by Panasonic Corporation, and the cross-sectional shape of the thermally conductive filler included in the cut surface of the heat dissipation sheet was image-analyzed using software image pro.

In the SEM image, the aggregate particles of hexagonal boron nitride appear darker than those of the silicone resin.

For all of the aggregate particles of hexagonal boron nitride included in the observation region, the Feret diameter (D) in the thickness direction and the Feret diameter (W) in the plane direction were measured, and the biaxial average diameter represented by the formula (I) $[(D + W)/2]$ was measured.

The average value of the aspect ratios measured for the top 24 biaxial average diameters was 0.5. Since the average value of the aspect ratio was within the specified range (0.4 to 1.4), it was found that the aggregate particles were not so much crushed in the production process of the heat dissipation sheet. The aspect ratio (D/W) is shown in Table 1.

(Characteristics of Heat Dissipation Sheet)

(1) Insulating property

The insulating property was evaluated based on a value obtained by measuring the dielectric breakdown voltage of the heat dissipation sheet by a short-time breakdown test (room temperature: 23°C) in accordance with the method described in JIS C2110. The results are shown in Table 1.

The evaluation criteria of the insulating property are as follows.

    A: The dielectric breakdown voltage is 5kV or more
    B: The dielectric breakdown voltage is 3kV or more and less than 5kV
    C: The dielectric breakdown voltage is less than 3kV

(2) Thermal conductivity

Thermal conductivity was evaluated based on the value obtained by measuring the thermal resistance of the heat dissipation sheet in accordance with the method described in ASTM D5470. The results are shown in Table 1.

The evaluation criteria of the thermal conductivity are as follows.

    A: The thermal conductivity is 5 W/(m·K) or more
    B: The thermal conductivity is 3 W/(m·K) or more and less than 5 W/(m·K)
    C: The thermal conductivity is less than 3 W/(m·K)

[Example 2] (not falling under the protection scope of the present disclosure)

A heat dissipation sheet was produced in the same manner as in Example 1 except that 80 g of aggregate particles of hexagonal boron nitride (crushing strength: 1 MPa, particle size: 20 μm) were added to 10 g of a silicone resin (manufactured by Wacker Asahikasei Silicone Co., Ltd., Model No.: LR3303-20A) and 10 g of a silicone resin (manufactured by Wacker Asahikasei Silicone Co., Ltd., Model No.: LR3303-20B).

As a result of measuring the top 24 biaxial average diameters in the same manner as in Example 1, the average value of the aspect ratio was 0.8. Since the average value of the aspect ratio was within the specified range (0.4 to 1.4), it was found that the aggregate particles were not so much crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Example 3]

A heat dissipation sheet was produced in the same manner as in Example 1 except that 70 g of aggregate particles of hexagonal boron nitride (crushing strength: 12 MPa, particle size: 50 μm) were added to 15 g of a silicone resin (manufactured by Wacker Asahikasei Silicone Co., Ltd., Model No.: LR3303-20A) and 15g of a silicone resin (manufactured by Wacker Asahikasei Silicone Co., Ltd., Model No.: LR3303-20B).

As a result of measuring the top 24 biaxial average diameters in the same manner as in Example 1, the average value of the aspect ratio was 1.0. Since the average value of the aspect ratio was within the specified range (0.4 to 1.4), it was found that the aggregate particles were not so much crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Example 4]

A heat dissipation sheet was produced in the same manner as in Example 1 except that 75 g of aggregate particles of hexagonal boron nitride (crushing strength: 12 MPa, particle size: 50 μm) were added to 12.5 g of a silicone resin (manufactured by Wacker Asahikasei Silicone Co., Ltd., Model No.: LR3303-20A) and 12.5 g of a silicone resin (manufactured by Wacker Asahikasei Silicone Co., Ltd., Model No.: LR3303-20B).

As a result of measuring the top 24 biaxial average diameters in the same manner as in Example 1, the average value of the aspect ratio was 1.1. Since the average value of the aspect ratio was within the specified range (0.4 to 1.4), it was found that the aggregate particles were not so much crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Example 5]

A heat dissipation sheet was produced in the same manner as in Example 1 except that 85 g of aggregate particles of hexagonal boron nitride (crushing strength: 12 MPa, particle size: 50 μm) were added to 7.5 g of a silicone resin (manufactured by Wacker Asahikasei Silicone Co., Ltd., Model No.: LR3303-20A) and 7.5 g of a silicone resin (manufactured by Wacker Asahikasei Silicone Co., Ltd., Model No.: LR3303-20B).

As a result of measuring the top 24 biaxial average diameters in the same manner as in Example 1, the average value of the aspect ratio was 1.2. Since the average value of the aspect ratio was within the specified range (0.4 to 1.4), it was found that the aggregate particles were not so much crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Example 6]

A heat dissipation sheet was produced in the same manner as in Example 1 except that 75 g of aggregate particles of hexagonal boron nitride (crushing strength: 12 MPa, particle size: 50 μm) and 10 g of silica (particle size: 0.5 μm) were added to 7.5 g of a silicone resin (manufactured by Wacker Asahikasei Silicone Co., Ltd., Model No.: LR3303-20A) and 7.5g of a silicone resin (manufactured by Wacker Asahikasei Silicone Co., Ltd., Model No.: LR3303-20B).

As a result of measuring the top 24 biaxial average diameters in the same manner as in Example 1, the average value of the aspect ratio was 0.7. Since the average value of the aspect ratio was within the specified range (0.4 to 1.4), it was found that the aggregate particles were not so much crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

**EP 4 105 173 B1**

[Example 7]

A heat dissipation sheet was produced in the same manner as in Example 1 except that 65 g of aggregate particles of hexagonal boron nitride (crushing strength: 12 MPa, particle size: 50 $\mu$m) and 10 g of alumina (particle size: 0.5 $\mu$m) were added to 12.5 g of a silicone resin (manufactured by Wacker Asahikasei Silicone Co., Ltd., Model No.: LR3303-20A) and 12.5g of a silicone resin (manufactured by Wacker Asahikasei Silicone Co., Ltd., Model No.: LR3303-20B).

As a result of measuring the top 24 biaxial average diameters in the same manner as in Example 1, the average value of the aspect ratio was 0.7. Since the average value of the aspect ratio was within the specified range (0.4 to 1.4), it was found that the aggregate particles were not so much crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Comparative Example 1]

A heat dissipation sheet was produced in the same manner as in Example 1 except that 70 g of aggregate particles of hexagonal boron nitride (crushing strength: 1 MPa, particle size: 20 $\mu$m) were added to 15 g of a silicone resin (manufactured by Wacker Asahikasei Silicone Co., Ltd., Model No.: LR3303-20A) and 15 g of a silicone resin (manufactured by Wacker Asahikasei Silicone Co., Ltd., Model No.: LR3303-20B), and that the preheating and pressurizing step was not performed.

As a result of measuring the top 24 biaxial average diameters in the same manner as in Example 1, the average value of the aspect ratios was 0.2, which was out of the specified range (0.4 to 1.4). Therefore, it was found that the aggregate particles were crushed in the production process of the heat dissipation sheet.

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Comparative Example 2]

An attempt was made to produce a heat dissipation sheet in the same manner as in Example 1 except that 95 g of aggregate particles of hexagonal boron nitride (crushing strength: 1 MPa, particle size: 20 $\mu$m) were added to 2.5 g of a silicone resin (manufactured by Wacker Asahikasei Silicone Co., Ltd., Model No.: LR3303-20A) and 2.5 g of a silicone resin (manufactured by Wacker Asahikasei Silicone Co., Ltd., Model No.: LR3303-20B), but the heat dissipation sheet could not be formed and could not be evaluated.

The mix proportion of the composition is shown in Table 1.

[Comparative Example 3]

A heat dissipation sheet was produced in the same manner as in Example 1 except that 65 g of aggregate particles of hexagonal boron nitride (crushing strength: 1 MPa, particle size: 20 $\mu$m) were added to 17.5 g of a silicone resin (manufactured by Wacker Asahikasei Silicone Co., Ltd., Model No.: LR3303-20A) and 17.5 g of a silicone resin (manufactured by Wacker Asahikasei Silicone Co., Ltd., Model No.: LR3303-20B).

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

[Comparative Example 4]

An attempt was made to produce a heat dissipation sheet in the same manner as in Example 1 except that 95 g of aggregate particles of hexagonal boron nitride (crushing strength: 12 MPa, particle size: 50 $\mu$m) were added to 2.5 g of a silicone resin (manufactured by Wacker Asahikasei Silicone Co., Ltd., Model No.: LR3303-20A) and 2.5 g of a silicone resin (manufactured by Wacker Asahikasei Silicone Co., Ltd., Model No.: LR3303-20B), but the heat dissipation sheet could not be formed and could not be evaluated.

[Comparative Example 5]

A heat dissipation sheet was produced in the same manner as in Example 1 except that 65 g of aggregate particles of hexagonal boron nitride (crushing strength: 12 MPa, particle size: 50 $\mu$m) were added to 17.5 g of a silicone resin (manufactured by Wacker Asahikasei Silicone Co., Ltd., Model No.: LR3303-20A) and 17.5 g of a silicone resin (manufactured by Wacker Asahikasei Silicone Co., Ltd., Model No.: LR3303-20B).

The mix proportion of the composition, the average value of the aspect ratio measured in the same manner as in Example 1, and the results of evaluation based on the values of the dielectric breakdown voltage and the thermal resistance of the obtained heat dissipation sheet are shown in Table 1.

Table 1 (Examples 1 and 2 are not falling under the protection scope of the present disclosure)

| Mix proportion | | | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 | Comp. Ex. 4 | Comp. Ex. 5 |
|---|---|---|---|---|---|---|---|---|---|---|---|---|---|---|
| Thermally conductive filler | Boron nitride | Compressive strength (MPa) | 1 | 1 | 12 | 12 | 12 | 12 | 12 | 1 | 1 | 1 | 12 | 12 |
| | | Particle size ($\mu$m) | 20 | 20 | 50 | 50 | 50 | 50 | 50 | 20 | 20 | 20 | 50 | 50 |
| | | Blending amount (% by mass) | 70 | 80 | 70 | 75 | 85 | 75 | 65 | 70 | 95 | 65 | 95 | 65 |
| | Alumina | Particle size ($\mu$m) | | | | | | | 0.5 | | | | | |
| | | Blending amount (% by mass) | | | | | | | 10 | | | | | |
| | Silica | Particle size ($\mu$m) | | | | | | 0.5 | | | | | | |
| | | Blending amount (% by mass) | | | | | | 10 | | | | | | |
| Silicone resin (Total) | | Blending amount (% by mass) | 30 | 20 | 30 | 25 | 15 | 15 | 25 | 30 | 5 | 35 | 5 | 35 |
| Aspect ratio D/W | | | 0.5 | 0.8 | 1 | 1.1 | 1.2 | 0.7 | 0.7 | 0.2 | - | 0.4 | - | 0.8 |
| Insulating property | | | A | A | B | B | B | A | A | C | - | C | - | C |
| Thermal conductivity | | | B | A | A | A | A | B | A | B | - | A | - | A |

In the heat dissipation sheets of Examples 1 to 7, since the average value of the aspect ratio was within the specified range (0.4 to 1.4), both the insulating property and the thermal conductivity were excellent. In particular, when aggregate particles of hexagonal boron nitride were used alone, both the insulating property and the thermal conductivity were very excellent.

On the other hand, in Comparative Example 1 in which the preheating and pressurizing step was not performed, the aggregate particles were crushed and the insulating property was deteriorated.

2. Second Embodiment

[Example 8]

(Preparation of Composition for Heat Dissipation Sheet)

After adding 80 g of aggregate particles of hexagonal boron nitride (crushing strength: 11 MPa, particle size: 48 μm) to 10 g of a silicone resin (manufactured by Wacker Asahikasei Silicone Co., Ltd., Model No.: LR3303-20A) and 10g of a silicone resin (manufactured by Wacker Asahikasei Silicone Co., Ltd., Model No.: LR3303-20B), toluene was added as a viscosity modifier so that the solid concentration was 70% by weight, and the mixture was mixed for 15 hours with a stirrer (trade name: HEIDON Three-One Motor, manufactured by SHINTO Scientific Co., Ltd.) equipped with a turbine type stirring blade to prepare a composition for a heat dissipation sheet. The mix proportion of the composition is shown in Table 2.

(Production of Heat Dissipation Sheet)

After a glass cloth (trade name: H25F 104, manufactured by Unitika Ltd.) was arranged on a Teflon (registered trademark) sheet, the above composition for a heat dissipation sheet was coated on the glass cloth with a comma coater to a thickness of 0.2 mm, and dried at 75°C for 5 minutes. Next, the dried composition for a heat dissipation sheet was turned upside down so that the glass cloth was on the upper side, coated onto the glass cloth with a comma coater to a thickness of 0.2 mm, and dried at 75°C for 5 minutes to prepare a sheet of the composition for a heat dissipation sheet in which the composition for a heat dissipation sheet was coated on both surfaces of the glass cloth. Thereafter, pressing was performed for 15 minutes under conditions of a preheating temperature of 70°C and a pressure of 120 kgf/cm$^2$ using a flat plate press machine (manufactured by Yanase Seisakusho Co., Ltd.) (preheating and pressurizing step). Thereafter, the temperature was raised to 150°C at a heating rate of 10°C/min while performing pressing of a pressure of 150 kgf/cm$^2$. Then, pressing was performed for 45 minutes under the conditions of a heating temperature (a temperature equal to or higher than the curing starting temperature) of 150°C and a pressure of 150 kgf/cm$^2$ to prepare a heat dissipation sheet having a thickness of 0.30 mm. Subsequently, the resultant was heated at a temperature of 150°C for 4 hours under normal pressure to remove the low molecular weight siloxane, thereby producing a heat dissipation sheet. The content of the thermally conductive filler was 80% by mass with respect to 100% by mass in total of the silicone resin and the thermally conductive filler in the heat dissipation sheet.

(Internal Structure of Heat Dissipation Sheet)

The heat dissipation sheet was cut perpendicularly to the surface, and a reflection electronic image of the cut surface was imaged using a scanning electron microscope (SEM) (manufactured by Hitachi High-Tech Corporation, trade name: SU6600 type). The image data was transferred to a personal computer manufactured by Panasonic Corporation, and the cross-sectional shape of the thermally conductive filler included in the cut surface of the heat dissipation sheet was image-analyzed using software image pro.

In the SEM image, the aggregate particles of hexagonal boron nitride appear darker than those of the silicone resin.

For all of the aggregate particles of hexagonal boron nitride included in the observation region, the Feret diameter (D) in the thickness direction and the Feret diameter (W) in the plane direction were measured, and an area ratio (Sr) of a total area S of cross-sectional shapes of the 1st to 24th particles from the largest with respect to the whole area of the observation region was calculated. The area ratio is shown in Table 2.

(Characteristics of Heat Dissipation Sheet)

(1) Dielectric breakdown voltage

Measurement and evaluation were performed in the same manner as in the First Embodiment.

(2) Thermal resistance

Measurement and evaluation were performed in the same manner as in the First Embodiment.

[Example 9] (not falling under the protection scope of the present disclosure)

A heat dissipation sheet was produced in the same manner as in Example 8 except that 80 g of aggregate particles of hexagonal boron nitride (crushing strength: 1.5 MPa, particle size: 18 $\mu$m) were added to 10 g of a silicone resin (manufactured by Wacker Asahikasei Silicone Co., Ltd., Model No.: LR3303-20A) and 10 g of a silicone resin (manufactured by Wacker Asahikasei Silicone Co., Ltd., Model No.: LR3303-20B).
As a result of measuring the top 24 biaxial average diameters in the same manner as in Example 8, the area ratio (Sr) was 27%, which was within the specified range (20 to 80%).
The mix proportion of the composition, the area ratio measured in the same manner as in Example 8, and the results of evaluation based on the values of the dielectric breakdown voltage and the thermal resistance of the obtained heat dissipation sheet are shown in Table 2.

[Example 10]

A heat dissipation sheet was produced in the same manner as in Example 8 except that 80 g of aggregate particles of hexagonal boron nitride (crushing strength: 11 MPa, particle size: 48 $\mu$m) and 5 g of alumina (particle size: 0.5 $\mu$m) were added to 7.5 g of a silicone resin (manufactured by Wacker Asahikasei Silicone Co., Ltd., Model No.: LR3303-20A) and 7.5g of a silicone resin (manufactured by Wacker Asahikasei Silicone Co., Ltd., Model No.: LR3303-20B).
As a result of measuring the top 24 biaxial average diameters in the same manner as in Example 8, the area ratio (Sr) was 70%, which was within the specified range (20 to 80%).
The mix proportion of the composition, the area ratio measured in the same manner as in Example 8, and the results of evaluation based on the values of the dielectric breakdown voltage and the thermal resistance of the obtained heat dissipation sheet are shown in Table 2.

[Example 11]

A heat dissipation sheet was produced in the same manner as in Example 8 except that 75 g of aggregate particles of hexagonal boron nitride (crushing strength: 11 MPa, particle size: 48 $\mu$m) were added to 12.5 g of a silicone resin (manufactured by Wacker Asahikasei Silicone Co., Ltd., Model No.: LR3303-20A) and 12.5 g of a silicone resin (manufactured by Wacker Asahikasei Silicone Co., Ltd., Model No.: LR3303-20B).
As a result of measuring the top 24 biaxial average diameters in the same manner as in Example 8, the area ratio (Sr) was 56%, which was within the specified range (20 to 80%).
The mix proportion of the composition, the area ratio measured in the same manner as in Example 8, and the results of evaluation based on the values of the dielectric breakdown voltage and the thermal resistance of the obtained heat dissipation sheet are shown in Table 2.

[Example 12]

A heat dissipation sheet was produced in the same manner as in Example 8 except that 65 g of aggregate particles of hexagonal boron nitride (crushing strength: 11 MPa, particle size: 48 $\mu$m) and 10 g of alumina (particle size: 0.5 $\mu$m) were added to 12.5 g of a silicone resin (manufactured by Wacker Asahikasei Silicone Co., Ltd., Model No.: LR3303-20A) and 12.5g of a silicone resin (manufactured by Wacker Asahikasei Silicone Co., Ltd., Model No.: LR3303-20B).
As a result of measuring the top 24 biaxial average diameters in the same manner as in Example 8, the area ratio (Sr) was 56%, which was within the specified range (20 to 80%).
The mix proportion of the composition, the area ratio measured in the same manner as in Example 8, and the results of evaluation based on the values of the dielectric breakdown voltage and the thermal resistance of the obtained heat dissipation sheet are shown in Table 2.

[Comparative Example 6]

A heat dissipation sheet was produced in the same manner as in Example 8 except that 80 g of aggregate particles of hexagonal boron nitride (crushing strength: 1.5 MPa, particle size: 18 $\mu$m) were added to 10 g of a silicone resin (manufactured by Wacker Asahikasei Silicone Co., Ltd., Model No.: LR3303-20A) and 10 g of a silicone resin (manufactured by Wacker Asahikasei Silicone Co., Ltd., Model No.: LR3303-20B), and that the preheating and pressurizing step was not performed.

As a result of measuring the top 24 biaxial average diameters in the same manner as in Example 8, the area ratio (Sr) was 22%, which was outside the specified range (20 to 80%).

In the same manner as in Example 8, the heat dissipation sheet was cut perpendicularly to the surface thereof, the cut surface was imaged with a scanning electron microscope (SEM), and the cross-sectional shape of the thermally conductive filler included in the cut surface of the heat dissipation sheet was image-analyzed.

The mix proportion of the composition, the area ratio measured in the same manner as in Example 8, and the results of evaluation based on the values of the dielectric breakdown voltage and the thermal resistance of the obtained heat dissipation sheet are shown in Table 2.

[Comparative Example 7]

A heat dissipation sheet was produced in the same manner as in Example 8 except that 80 g of aggregate particles of hexagonal boron nitride (crushing strength: 12 MPa, particle size: 50 $\mu$m) were added to 10 g of a silicone resin (manufactured by Wacker Asahikasei Silicone Co., Ltd., Model No.: LR3303-20A) and 10 g of a silicone resin (manufactured by Wacker Asahikasei Silicone Co., Ltd., Model No.: LR3303-20B), and that the preheating and pressurizing step was not performed.

As a result of measuring the top 24 biaxial average diameters in the same manner as in Example 8, the area ratio (Sr) was 85%, which exceeded the specified range (20 to 80%).

The mix proportion of the composition, the area ratio measured in the same manner as in Example 8, and the results of evaluation based on the values of the dielectric breakdown voltage and the thermal resistance of the obtained heat dissipation sheet are shown in Table 2.

[Comparative Example 8]

An attempt was made to produce a heat dissipation sheet in the same manner as in Example 8 except that 95 g of aggregate particles of hexagonal boron nitride (crushing strength: 12 MPa, particle size: 50 $\mu$m) were added to 2.5 g of a silicone resin (manufactured by Wacker Asahikasei Silicone Co., Ltd., Model No.: LR3303-20A) and 2.5 g of a silicone resin (manufactured by Wacker Asahikasei Silicone Co., Ltd., Model No.: LR3303-20B), but the heat dissipation sheet could not be formed and could not be evaluated.

The mix proportion of the composition is shown in Table 2.

[Comparative Example 9]

A heat dissipation sheet was produced in the same manner as in Example 8 except that 60 g of aggregate particles of hexagonal boron nitride (crushing strength: 1 MPa, particle size: 20 $\mu$m) were added to 20 g of a silicone resin (manufactured by Wacker Asahikasei Silicone Co., Ltd., Model No.: LR3303-20A) and 20 g of a silicone resin (manufactured by Wacker Asahikasei Silicone Co., Ltd., Model No.: LR3303-20B).

As a result of measuring the top 24 biaxial average diameters in the same manner as in Example 8, the area ratio (Sr) was 35%, which was within the specified range (20 to 80%).

The mix proportion of the composition, the area ratio measured in the same manner as in Example 8, and the results of evaluation based on the values of the dielectric breakdown voltage and the thermal resistance of the obtained heat dissipation sheet are shown in Table 2.

Table 2 (Example 9 does not fall under the protection scope of the present invention)

| Mix proportion | | | Ex. 8 | Ex. 9 | Ex. 10 | Ex. 11 | Ex. 12 | Comp. Ex. 6 | Comp. Ex. 7 | Comp. Ex. 8 | Comp. Ex. 9 |
|---|---|---|---|---|---|---|---|---|---|---|---|
| Thermally conductive filler | Boron nitride | Compressive strength (MPa) | 11 | 1.5 | 11 | 11 | 11 | 1.5 | 12 | 12 | 1 |
| | | Particle size ($\mu$m) | 48 | 18 | 48 | 48 | 48 | 18 | 50 | 50 | 20 |
| | | Blending amount (% by mass) | 80 | 80 | 80 | 75 | 65 | 80 | 80 | 95 | 60 |
| | Alumina | Particle size ($\mu$m) | | | 0.5 | | 0.5 | | | | |
| | | Blending amount (% by mass) | | | 5 | | 10 | | | | |
| Silicone resin (Total) | | Blending amount (% by mass) | 20 | 20 | 15 | 25 | 25 | 20 | 20 | 5 | 40 |
| Area ratio Sr (%) | | | 68 | 27 | 70 | 56 | 56 | 19 | 85 | - | 35 |
| Insulating property | | | A | A | A | A | A | C | C | - | C |
| Thermal conductivity | | | A | A | A | A | A | A | B | - | A |

In the heat dissipation sheets of Examples 8 to 12, since the area ratio was within the specified range (20 to 80%), both the insulating property and the thermal conductivity were excellent. In particular, when aggregate particles of hexagonal boron nitride were used alone, both the insulating property and the thermal conductivity were very excellent.
On the other hand, in Comparative Example in which the preheating and pressurizing step was not performed, the insulating property was deteriorated.

3. Third Embodiment

[Example 13]

(Preparation of Composition for Heat Dissipation Sheet)

After adding 85 g of aggregate particles of hexagonal boron nitride (crushing strength: 9 MPa, particle size: 45 $\mu$m) to 7.5 g of a silicone resin (manufactured by Wacker Asahikasei Silicone Co., Ltd., Model No.: LR3303-20A) and 7.5g of a silicone resin (manufactured by Wacker Asahikasei Silicone Co., Ltd., Model No.: LR3303-20B), toluene was added as a viscosity modifier so that the solid concentration was 70% by weight, and the mixture was mixed for 15 hours with a stirrer (trade name: HEIDON Three-One Motor, manufactured by SHINTO Scientific Co., Ltd.) equipped with a turbine type stirring blade to prepare a composition for a heat dissipation sheet.

(Production of Heat Dissipation Sheet)

After a glass cloth (trade name: H25F 104, manufactured by Unitika Ltd.) was arranged on a Teflon (registered trademark) sheet, the above composition for a heat dissipation sheet was coated on the glass cloth with a comma coater to a thickness of 0.2 mm, and dried at 75°C for 5 minutes. Next, the dried composition for a heat dissipation sheet was turned upside down so that the glass cloth was on the upper side, coated onto the glass cloth with a comma coater to a thickness of 0.2 mm, and dried at 75°C for 5 minutes to prepare a sheet of the composition for a heat dissipation sheet in which the composition for a heat dissipation sheet was coated on both surfaces of the glass cloth. Thereafter, pressing was performed for 15 minutes under conditions of a preheating temperature of 70°C and a pressure of 120 kgf/cm$^2$ using a flat plate press machine (manufactured by Yanase Seisakusho Co., Ltd.) (preheating and pressurizing step). Thereafter, the temperature was raised to 150°C at a heating rate of 10°C/min while performing pressing of a pressure of 150 kgf/cm$^2$. Then, pressing was performed for 45 minutes under the conditions of a heating temperature (a temperature equal to or higher than the curing starting temperature) of 150°C and a pressure of 150 kgf/cm$^2$ to prepare a heat dissipation sheet having a thickness of 0.30 mm. Subsequently, the resultant was heated at a temperature of 150°C for 4 hours under normal pressure to remove the low molecular weight siloxane, thereby producing a heat dissipation sheet. The content of the thermally conductive filler was 85% by mass with respect to 100% by mass in total of the silicone resin and the thermally conductive filler in the heat dissipation sheet.

(Internal Structure of Heat Dissipation Sheet)

The heat dissipation sheet was cut perpendicularly to the surface, and a reflection electronic image of the cut surface was imaged using a scanning electron microscope (SEM) (manufactured by Hitachi High-Tech Corporation, trade name: SU6600 type). The image data was transferred to a personal computer manufactured by Panasonic Corporation, and the cross-sectional shape of the thermally conductive filler included in the cut surface of the heat dissipation sheet was image-analyzed using software image pro.
In the SEM image, the aggregate particles of hexagonal boron nitride appear darker than those of the silicone resin.
For all of the aggregate particles of hexagonal boron nitride included in the observation region, the Feret diameter (D) in the thickness direction and the Feret diameter (W) in the plane direction were measured, and the biaxial average diameter represented by formula (I) [(D + W)/2] was measured.
The average value of the particle number ratios measured for the top 24 biaxial average diameters was 0.93, which was within the specified range (0.4 to 1). The particle number ratio is shown in Table 3.

(Characteristics of Heat Dissipation Sheet)

(1) Dielectric breakdown voltage

Measurement and evaluation were performed in the same manner as in the First Embodiment.

(2) Thermal resistance

Measurement and evaluation were performed in the same manner as in the First Embodiment.

[Example 14] (not falling under the protection scope of the present disclosure)

A heat dissipation sheet was produced in the same manner as in Example 13 except that 70 g of aggregate particles of hexagonal boron nitride (crushing strength: 2 MPa, particle size: 25 $\mu$m) were added to 15 g of a silicone resin (manufactured by Wacker Asahikasei Silicone Co., Ltd., Model No.: LR3303-20A) and 15 g of a silicone resin (manufactured by Wacker Asahikasei Silicone Co., Ltd., Model No.: LR3303-20B).
As a result of measuring the top 24 biaxial average diameters in the same manner as in Example 13, the particle number ratio was 0.51, which was within the specified range (0.4 to 1).
The mix proportion of the composition, the particle number ratio measured in the same manner as in Example 13, and the results of evaluation based on the values of the dielectric breakdown voltage and the thermal resistance of the obtained heat dissipation sheet are shown in Table 3.

[Example 15]

A heat dissipation sheet was produced in the same manner as in Example 13 except that 75 g of aggregate particles of hexagonal boron nitride (crushing strength: 11 MPa, particle size: 48 $\mu$m) and 10 g of alumina (particle size: 0.5 $\mu$m) were added to 7.5 g of a silicone resin (manufactured by Wacker Asahikasei Silicone Co., Ltd., Model No.: LR3303-20A) and 7.5g of a silicone resin (manufactured by Wacker Asahikasei Silicone Co., Ltd., Model No.: LR3303-20B).
As a result of measuring the top 24 biaxial average diameters in the same manner as in Example 13, the particle number ratio was 0.80, which was within the specified range (0.4 to 1).
The mix proportion of the composition, the particle number ratio measured in the same manner as in Example 13, and the results of evaluation based on the values of the dielectric breakdown voltage and the thermal resistance of the obtained heat dissipation sheet are shown in Table 3.

[Example 16] (not falling under the protection scope of the present disclosure)

A heat dissipation sheet was produced in the same manner as in Example 13 except that 75 g of aggregate particles of hexagonal boron nitride (crushing strength: 2 MPa, particle size: 25 $\mu$m) were added to 12.5 g of a silicone resin (manufactured by Wacker Asahikasei Silicone Co., Ltd., Model No.: LR3303-20A) and 12.5 g of a silicone resin (manufactured by Wacker Asahikasei Silicone Co., Ltd., Model No.: LR3303-20B).
As a result of measuring the top 24 biaxial average diameters in the same manner as in Example 13, the particle number ratio was 0.78, which was within the specified range (0.4 to 1).
The mix proportion of the composition, the particle number ratio measured in the same manner as in Example 13, and the results of evaluation based on the values of the dielectric breakdown voltage and the thermal resistance of the obtained heat dissipation sheet are shown in Table 3.

[Comparative Example 10]

A heat dissipation sheet was produced in the same manner as in Example 13 except that 50 g of aggregate particles of hexagonal boron nitride (crushing strength: 2 MPa, particle size: 25 $\mu$m) were added to 25 g of a silicone resin (manufactured by Wacker Asahikasei Silicone Co., Ltd., Model No.: LR3303-20A) and 25 g of a silicone resin (manufactured by Wacker Asahikasei Silicone Co., Ltd., Model No.: LR3303-20B).
As a result of measuring the top 24 biaxial average diameters in the same manner as in Example 13, the particle number ratio was 0.31, which was below the specified range (0.4 to 1).
The mix proportion of the composition, the particle number ratio measured in the same manner as in Example 13, and the results of evaluation based on the values of the dielectric breakdown voltage and the thermal resistance of the obtained heat dissipation sheet are shown in Table 3.

[Comparative Example 11]

An attempt was made to produce a heat dissipation sheet in the same manner as in Example 13 except that 95 g of aggregate particles of hexagonal boron nitride (crushing strength: 9 MPa, particle size: 45 $\mu$m) were added to 2.5 g of a silicone resin (manufactured by Wacker Asahikasei Silicone Co., Ltd., Model No.: LR3303-20A) and 2.5 g of a silicone resin (manufactured by Wacker Asahikasei Silicone Co., Ltd., Model No.: LR3303-20B), but the heat dissipation sheet could not be formed and could not be evaluated.

The mix proportion of the composition is shown in Table 3.

[Comparative Example 12]

A heat dissipation sheet was produced in the same manner as in Example 13 except that 60 g of aggregate particles of hexagonal boron nitride (crushing strength: 2 MPa, particle size: 25 µm) were added to 20 g of a silicone resin (manufactured by Wacker Asahikasei Silicone Co., Ltd., Model No.: LR3303-20A) and 20 g of a silicone resin (manufactured by Wacker Asahikasei Silicone Co., Ltd., Model No.: LR3303-20B).

As a result of measuring the top 24 biaxial average diameters in the same manner as in Example 13, the particle number ratio was 0.74, which was within the specified range (0.4 to 1).

The mix proportion of the composition, the particle number ratio measured in the same manner as in Example 13, and the results of evaluation based on the values of the dielectric breakdown voltage and the thermal resistance of the obtained heat dissipation sheet are shown in Table 3.

[Comparative Example 13]

A heat dissipation sheet was produced in the same manner as in Example 13 except that 70 g of aggregate particles of hexagonal boron nitride (crushing strength: 2 MPa, particle size: 25 µm) were added to 15 g of a silicone resin (manufactured by Wacker Asahikasei Silicone Co., Ltd., Model No.: LR3303-20A) and 15 g of a silicone resin (manufactured by Wacker Asahikasei Silicone Co., Ltd., Model No.: LR3303-20B), and that the preheating and pressurizing step was not performed.

As a result of measuring the top 24 biaxial average diameters in the same manner as in Example 13, the particle number ratio was 0.25, which was below the specified range (0.4 to 1).

The mix proportion of the composition, the particle number ratio measured in the same manner as in Example 13, and the results of evaluation based on the values of the dielectric breakdown voltage and the thermal resistance of the obtained heat dissipation sheet are shown in Table 3.

Table 3 (Examples 14 and 16 are not falling under the protection scope of the present disclosure)

| Mix proportion | | | Ex. 13 | Ex. 14 | Ex. 15 | Ex. 16 | Comp. Ex. 10 | Comp. Ex. 11 | Comp. Ex. 12 | Comp. Ex. 13 |
|---|---|---|---|---|---|---|---|---|---|---|
| Thermally conductive filler | Boron nitride | Compressive strength (MPa) | 9 | 2 | 11 | 2 | 2 | 9 | 2 | 2 |
| | | Particle size (µm) | 45 | 25 | 48 | 25 | 25 | 45 | 25 | 25 |
| | | Blending amount (% by mass) | 85 | 70 | 75 | 75 | 50 | 95 | 60 | 70 |
| | Alumina | Particle size (µm) | | | 0.5 | | | | | |
| | | Blending amount (% by mass) | | | 10 | | | | | |
| Silicone resin (Total) | | Blending amount (% by mass) | 15 | 30 | 15 | 25 | 50 | 5 | 40 | 30 |
| Ratio $n_w/n_d$ | | | 0.93 | 0.51 | 0.80 | 0.78 | 0.93 | - | 0.74 | 0.25 |
| Insulating property | | | A | B | A | A | C | - | C | C |
| Thermal conductivity | | | A | A | B | A | A | - | C | A |

In the heat dissipation sheets of Examples 13 to 16, since the particle number ratio was within the specified range (0.4 to 1), both the insulating property and the thermal conductivity were excellent. In particular, when aggregate particles of hexagonal boron nitride were used alone, both the insulating property and the thermal conductivity were very excellent.

On the other hand, in Comparative Example 4 in which the preheating and pressurizing step was not performed, the insulating property was deteriorated.

4. Fourth Embodiment

[Example 17] (not falling under the protection scope of the present disclosure)

(Preparation of Composition for Heat Dissipation Sheet)

After adding 63 g of aggregate particles of hexagonal boron nitride (crushing strength: 1 MPa, particle size: 22 $\mu$m) to 18.5 g of a silicone resin (manufactured by Wacker Asahikasei Silicone Co., Ltd., Model No.: LR3303-20A) and 18.5g of a silicone resin (manufactured by Wacker Asahikasei Silicone Co., Ltd., Model No.: LR3303-20B), toluene was added as a viscosity modifier so that the solid concentration was 70% by weight, and the mixture was mixed for 15 hours with a stirrer (trade name: HEIDON Three-One Motor, manufactured by SHINTO Scientific Co., Ltd.) equipped with a turbine type stirring blade to prepare a composition for a heat dissipation sheet.

(Production of Heat Dissipation Sheet)

After a glass cloth (trade name: H25F 104, manufactured by Unitika Ltd.) was arranged on a Teflon (registered trademark) sheet, the above composition for a heat dissipation sheet was coated on the glass cloth with a comma coater to a thickness of 0.2 mm, and dried at 75°C for 5 minutes. Next, the dried composition for a heat dissipation sheet was turned upside down so that the glass cloth was on the upper side, coated onto the glass cloth with a comma coater to a thickness of 0.2 mm, and dried at 75°C for 5 minutes to prepare a sheet of the composition for a heat dissipation sheet in which the composition for a heat dissipation sheet was coated on both surfaces of the glass cloth. Thereafter, pressing was performed for 15 minutes under conditions of a preheating temperature of 70°C and a pressure of 120 kgf/cm$^2$ using a flat plate press machine (manufactured by Yanase Seisakusho Co., Ltd.) (preheating and pressurizing step). Thereafter, the temperature was raised to 150°C at a heating rate of 10°C/min while performing pressing of a pressure of 150 kgf/cm$^2$. Then, pressing was performed for 45 minutes under the conditions of a heating temperature (a temperature equal to or higher than the curing starting temperature) of 150°C and a pressure of 150 kgf/cm$^2$ to prepare a heat dissipation sheet having a thickness of 0.30 mm. Subsequently, the resultant was heated at a temperature of 150°C for 4 hours under normal pressure to remove the low molecular weight siloxane, thereby producing a heat dissipation sheet A. The content of the thermally conductive filler was 63% by mass with respect to 100% by mass in total of the silicone resin and the thermally conductive filler in the heat dissipation sheet.

(Internal Structure of Heat Dissipation Sheet)

The heat dissipation sheet was cut perpendicularly to the surface, and a reflection electronic image of the cut surface was imaged using a scanning electron microscope (SEM) (manufactured by Hitachi High-Tech Corporation, trade name: SU6600 type).

In the SEM image, the aggregate particles of hexagonal boron nitride appear darker than those of the silicone resin.

(Characteristics of Heat Dissipation Sheet)

(1) Dielectric breakdown voltage

The dielectric breakdown voltage of the heat dissipation sheet was evaluated by a short-time discard test (room temperature: 23°C) in accordance with the method described in JIS C2110. The results are shown in Table 4.

(2) Thermal resistance

The thermal resistance of the heat dissipation sheet was evaluated in accordance with the method described in ASTM D5470. Thermal resistance values when pressures of 0.2 to 1.0 MPa were applied in the thickness direction were measured, respectively. When the thermal resistance value when a pressure of 0.2 MPa was applied was defined as $R_{0.2}$, the thermal resistance value when a pressure of 0.4 MPa was applied was defined as $R_{0.4}$, and the thermal resistance value when a pressure of 1.0 MPa was applied was defined as $R_{1.0}$, thermal resistance ratios $R_{0.2}/R_{1.0}$ and $R_{0.4}/R_{1.0}$ were calculated. The results are shown in Table 4.

[Example 18] (not falling under the protection scope of the present disclosure)

A heat dissipation sheet was produced in the same manner as in Example 17 except that 70 g of aggregate particles of hexagonal boron nitride (crushing strength: 1 MPa, particle size: 22 $\mu$m) were added to 15 g of a silicone resin (manufactured by Wacker Asahikasei Silicone Co., Ltd., Model No.: LR3303-20A) and 15 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 19]

A heat dissipation sheet was produced in the same manner as in Example 17 except that 77 g of aggregate particles of hexagonal boron nitride (crushing strength: 3 MPa, particle size: 60 $\mu$m) and 10 g of alumina (particle size: 5 $\mu$m) were added to 6.5 g of a silicone resin (manufactured by Wacker Asahikasei Silicone Co., Ltd., Model No.: LR3303-20A) and 6.5g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 20] (not falling under the protection scope of the present disclosure)

A heat dissipation sheet was produced in the same manner as in Example 17 except that 63 g of aggregate particles of hexagonal boron nitride (crushing strength: 2 MPa, particle size: 70 $\mu$m) were added to 18.5 g of a silicone resin (manufactured by Wacker Asahikasei Silicone Co., Ltd., Model No.: LR3303-20A) and 18.5 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 21] (not falling under the protection scope of the present disclosure)

A heat dissipation sheet was produced in the same manner as in Example 17 except that 63 g of aggregate particles of hexagonal boron nitride (crushing strength: 10 MPa, particle size: 50 $\mu$m) were added to 18.5 g of a silicone resin (manufactured by Wacker Asahikasei Silicone Co., Ltd., Model No.: LR3303-20A) and 18.5 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 22]

A heat dissipation sheet was produced in the same manner as in Example 17 except that 70 g of aggregate particles of hexagonal boron nitride (crushing strength: 1 MPa, particle size: 22 $\mu$m) were added to 15 g of a silicone resin (manufactured by Wacker Asahikasei Silicone Co., Ltd., Model No.: LR3303-20A) and 15 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 23] (not falling under the protection scope of the present disclosure)

A heat dissipation sheet was produced in the same manner as in Example 17 except that 45 g of aggregate particles of hexagonal boron nitride (crushing strength: 1 MPa, particle size: 22 $\mu$m) and 15 g of alumina (particle size: 5 $\mu$m) were added to 20 g of a silicone resin (manufactured by Wacker Asahikasei Silicone Co., Ltd., Model No.: LR3303-20A) and 20 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 24] (not falling under the protection scope of the present disclosure)

A heat dissipation sheet was produced in the same manner as in Example 17 except that 40 g of aggregate particles of hexagonal boron nitride (crushing strength: 1 MPa, particle size: 22 μm) and 30 g of silica (particle size: 5 μm) were added to 15 g of a silicone resin (manufactured by Wacker Asahikasei Silicone Co., Ltd., Model No.: LR3303-20A) and 15 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Example 25] (not falling under the protection scope of the present disclosure)

A heat dissipation sheet was produced in the same manner as in Example 17 except that 85 g of alumina (particle size: 18 μm) was added to 7.5 g of a silicone resin (manufactured by Wacker Asahikasei Silicone Co., Ltd., Model No.: LR3303-20A) and 7.5 g of a silicone resin (manufactured by Wacker Asahikasei Silicone Co., Ltd., Model No.: LR3303-20B).
The mix proportion of the composition and the values of the dielectric breakdown voltage and the thermal resistance of the heat dissipation sheet measured in the same manner as in Example 17 are shown in Table 4.

[Comparative Example 14]

A heat dissipation sheet was produced in the same manner as in Example 17 except that 74 g of aggregate particles of hexagonal boron nitride (crushing strength: 1.5 MPa, particle size: 32 μm) were added to 13 g of a silicone resin (manufactured by Wacker Asahikasei Silicone Co., Ltd., Model No.: LR3303-20A) and 13 g of a silicone resin (manufactured by Wacker Asahikasei Silicone Co., Ltd., Model No.: LR3303-20B), and that the preheating and pressurizing step was not performed.
The mix proportion of the composition and the values of the dielectric breakdown voltage and the thermal resistance of the heat dissipation sheet measured in the same manner as in Example 17 are shown in Table 4.

[Comparative Example 15]

A heat dissipation sheet was produced in the same manner as in Example 17 except that 67 g of aggregate particles of hexagonal boron nitride (crushing strength: 1.5 MPa, particle size: 32 μm) were added to 16.5 g of a silicone resin (manufactured by Wacker Asahikasei Silicone Co., Ltd., Model No.: LR3303-20A) and 16.5 g of a silicone resin (manufactured by Wacker Asahikasei Silicone Co., Ltd., Model No.: LR3303-20B), and that the preheating and pressurizing step was not performed.
The mix proportion of the composition and the values of the dielectric breakdown voltage and the thermal resistance of the heat dissipation sheet measured in the same manner as in Example 17 are shown in Table 4.

Table 4 (Examples 17, 18, 20, 21, 23 ,24, 25 are not falling under the protection scope of the present disclosure)

| Mix proportion | | | Ex. 17 | Ex. 18 | Ex. 19 | Ex. 20 | Ex. 21 | Ex. 22 | Ex. 23 | Ex. 24 | Ex. 25 | Comp. Ex. 14 | Comp. Ex. 15 |
|---|---|---|---|---|---|---|---|---|---|---|---|---|---|
| Thermally conductive filler | Boron nitride | Compressive strength (MPa) | 1 | 1 | 3 | 2 | 10 | 10 | 1 | 1 | | 1.5 | 1.5 |
| | | Particle size ($\mu$m) | 22 | 22 | 60 | 70 | 50 | 50 | 22 | 22 | | 32 | 32 |
| | | Blending amount (% by mass) | 63 | 70 | 77 | 63 | 63 | 70 | 45 | 40 | | 74 | 67 |
| | Alumina | Particle size ($\mu$m) | | | 5 | | | | 5 | | 18 | | |
| | | Blending amount (% by mass) | | | 10 | | | | 15 | | 85 | | |
| Silicone resin (Total) | | Blending amount (% by mass) | 37 | 30 | 13 | 37 | 37 | 30 | 40 | 30 | 15 | 26 | 33 |
| Dielectric breakdown voltage (kV) | | | 9.1 | 10.5 | 6.7 | 8.1 | 7.3 | 7.5 | 8.1 | 9.1 | 7.5 | 3.4 | 4.5 |
| Thermal resistance (°C/W) | | R0.2 | 1.63 | 2.28 | 1.21 | 1.45 | 1.30 | 1.00 | 2.60 | 3.88 | 3.49 | 0.71 | 0.63 |
| | | R0.4 | 1.31 | 1.89 | 1.01 | 1.07 | 0.85 | 0.80 | 2.33 | 3.70 | 2.97 | 0.65 | 0.61 |
| | | R1.0 | 0.93 | 1.40 | 0.75 | 0.72 | 0.67 | 0.63 | 1.88 | 3.19 | 2.39 | 0.74 | 0.74 |
| Thermal resistance ratio | | R0.2/R1.0 | 1.75 | 1.63 | 1.61 | 2.01 | 1.94 | 1.59 | 1.38 | 1.22 | 1.46 | 0.96 | 0.85 |
| | | R0.4/R1.0 | 1.41 | 1.35 | 1.35 | 1.49 | 1.27 | 1.27 | 1.24 | 1.16 | 1.24 | 0.88 | 0.82 |

In the heat dissipation sheets of Examples 17 to 25 using the aggregate particles of hexagonal boron nitride, the dielectric breakdown voltage was 5.0 kV or more, and both of the thermal resistance ratios $R_{0.2}/R_{1.0}$ and $R_{0.4}/R_{1.0}$ were 1 or more. In other words, the heat dissipation sheet of the present invention is not only excellent in insulating property, but also does not break the heat conduction path under a high loading pressure (1.0 MPa). In particular, the heat dissipation sheets of Examples 17 to 25 in which only aggregate particles of hexagonal boron nitride were used had a thermal resistance of 1.5°C/W or less under a high loading pressure (1.0 MPa), had a low absolute value of thermal resistance, and were most suitable for automobile applications.

On the other hand, the heat dissipation sheets of Comparative Examples 14 and 15, which were not subjected to the preheating and pressurizing step, had a dielectric breakdown voltage of less than 5.0 kV, and had a problem in insulating property. The thermal resistance ratios $R_{0.2}/R_{1.0}$ and $R_{0.4}/R_{1.0}$ were also less than 1.

With respect to the heat dissipation sheets of Examples 17 to 25, when the pressure load increases from 0.2 MPa to 0.4 MPa and further to 1.0 MPa, the thermal resistance decreases. It is considered that this is because the distribution density of the thermally conductive particles in the thickness direction is increased (that is, the distance between the particles is shortened) and the thermal conductivity is improved due to the decrease in the thickness of the heat dissipation sheet by the pressure load.

On the other hand, with respect to the heat dissipation sheets of Comparative Examples 14 and 15, the thermal resistance decreases as the pressure load increases from 0.2 MPa to 0.4 MPa, but when the pressure load further increases to 1.0 MPa, the thermal resistance increases again. This suggests that when the pressure load exceeds 0.4 MPa and rises to 1.0 MPa, the compression of the heat dissipation sheet destroys the internal heat conduction path.

In addition, when the internal structures of Examples 17 to 19 were checked, it could be confirmed that the average value of the aspect ratio was in a range of 0.4 or more and 1.4 or less similarly to the first aspect.

When the internal structures of Examples 20 to 22 were checked, it was confirmed that the area ratio (Sr) was in a range of 20% or more and 80% or less as in the second aspect.

When the internal structures of Examples 23 to 25 were checked, it was confirmed that the particle number ratio $n_w/n_d$ was in a range of 0.4 or more and less than 1 as in the third aspect.

As described above, it was confirmed that it is important to set the thermal resistance ratio $R_{0.4}/R_{1.0}$ to 1 or more and adjust the dielectric breakdown voltage to be in a predetermined range so as to reduce voids.

Industrial Applicability

Since the heat dissipation sheet of the present invention exhibits excellent thermal conductivity and insulating property even when a heat sink is attached under a high fastening pressure, it can protect heat-generating electronic components from thermal damage not only in ordinary applications but also in in-vehicle applications.

Reference Signs List

1: Electronic component
2: Heat sink
3: Air layer
4: Heat dissipation sheet
10: Heat dissipation sheet
11: Silicone resin
12: Thermally conductive filler
12a: Thermally conductive filler to be observed (thermally conductive filler of aggregate particles)
12b: Thermally conductive filler not to be observed (thermally conductive filler of scale-like primary particles)

**Claims**

1. A heat dissipation sheet comprising a silicone resin and a thermally conductive filler, wherein

the content of the silicone resin is 10 to 30% by mass and the content of the thermally conductive filler is 70 to 90% by mass based on 100% by mass of the total amount of the silicone resin and the thermally conductive filler, and wherein, in a cross-sectional view in the thickness direction from one surface to the other surface of the heat dissipation sheet, when the cross-sectional shape of the thermally conductive filler is such that the Feret diameter in the thickness direction is represented by D and the Feret diameter in the plane direction is represented by W, with respect to the 1st to 24th particles from the largest of biaxial average diameters represented by formula (I):

the average value of an aspect ratio represented by formula (II) is in a range of 0.4 or more and 1.4 or less, or an area ratio (Sr) of a total area S of cross-sectional shapes of a plurality of the particles to a whole area of the cross-sectional view is in a range of 20% or more and 80% or less, or a particle number ratio, $n_w/n_d$, of a number of particles per 10 $\mu$m of a straight line traversed by the straight line drawn at 20 $\mu$m intervals parallel to the plane direction, $n_w$, and a number of particles per 10 $\mu$m of a straight line traversed by the straight line drawn at 20 $\mu$m intervals parallel to the thickness direction, $n_d$, is in a range of 0.4 or more and less than 1,

$$(D + W)/2 \qquad (I)$$

$$D/W \qquad (II);$$

and

the thermally conductive filler comprises aggregate particles having an average particle diameter of 30 $\mu$m or more measured by laser diffraction scattering and formed by aggregation of scale-like primary particles of boron nitride, a proportion of the aggregate particles in the total amount of the thermally conductive filler is 90% by mass or more, and a crushing strength of the aggregate particles is 1 to 40 MPa measured in accordance with JIS R1639-5.

2. A method for producing a heat dissipation sheet according to claim 1 containing a silicone resin and a thermally conductive filler, which comprises:

a composition preparing step of preparing a composition by mixing 10 to 30% by mass of the silicone resin and 70 to 90% by mass of the thermally conductive filler based on 100% by mass of the total amount of the silicone resin and the thermally conductive filler; a sheet forming step of forming the composition into a sheet after the composition preparing step; a preheating step of preheating the sheet at a preheating temperature lower than a curing starting temperature while pressurizing the sheet after the sheet forming step; and a curing step of heating the preheated sheet at a temperature equal to or higher than the curing starting temperature while pressurizing the sheet after the preheating step, wherein a pressure in the preheating step is $4.9*10^6$ to $1.96*10^7$ Pa (50 to 200kgf/cm$^2$), the preheating temperature in the preheating step is 50 to 80°C, a pressure in the curing step is $9.6*10^6$ to $1.96*10^7$ Pa (100 to 200kgf/cm$^2$), and a temperature in the curing step is 130 to 200°C.

**Patentansprüche**

1. Wärmeableitungsfolie, umfassend ein Silikonharz und einen wärmeleitenden Füllstoff, wobei

der Gehalt des Silikonharzes 10 bis 30 Masse-% beträgt und der Gehalt des wärmeleitenden Füllstoffs 70 bis 90 Masse-% beträgt, basierend auf 100 Masse-% der Gesamtmenge des Silikonharzes und des wärmeleitenden Füllstoffs, und wobei in einer Querschnittsansicht in der Dickenrichtung von einer Oberfläche zu der anderen Oberfläche der Wärmeableitungsfolie, wenn die Querschnittsform des wärmeleitenden Füllstoffs so ist, dass der Feret-Durchmesser in der Dickenrichtung durch D dargestellt ist und der Feret-Durchmesser in der Ebenenrichtung durch W dargestellt ist, in Bezug auf das 1. bis 24. Partikel vom größten der biaxialen durchschnittlichen Durchmesser, dargestellt durch Formel (I):

der Durchschnittswert eines durch Formel (II) dargestellten Seitenverhältnisses in einem Bereich von 0,4 oder mehr und 1,4 oder weniger liegt, oder ein Flächenverhältnis (Sr) einer Gesamtfläche S von Querschnittsformen einer Vielzahl von Partikeln zu einer gesamten Fläche der Querschnittsansicht in einem Bereich von 20 % oder mehr und 80 % oder weniger liegt, oder

ein Partikelanzahlverhältnis, $n_w/n_d$, einer Anzahl von Partikeln pro 10 $\mu$m einer geraden Linie, die von der in 20-$\mu$m-Intervallen parallel zur Ebenenrichtung gezogenen geraden Linie gekreuzt wird, $n_w$, und einer Anzahl von Partikeln pro 10 $\mu$m einer geraden Linie, die von der in 20-$\mu$m-Intervallen parallel zur Dickenrichtung gezogenen geraden Linie gekreuzt wird, $n_d$, in einem Bereich von 0,4 oder mehr und weniger als 1 liegt,

$$(D + W)/2 \qquad (I)$$

$$D/W \qquad (II);$$

und

der wärmeleitende Füllstoff Aggregatpartikel mit einem durchschnittlichen Partikeldurchmesser von 30 $\mu$m oder mehr, durch Laserbeugungsstreuung gemessen und durch Aggregation von schuppenartigen Primärpartikeln aus Bornitrid ausgebildet, umfasst,
ein Anteil der Aggregatpartikel an der Gesamtmenge des wärmeleitenden Füllstoffs 90 Masse-% oder mehr beträgt, und
eine Druckfestigkeit der Aggregatpartikel 1 bis 40 MPa, gemessen gemäß JIS R1639-5, beträgt.

2. Verfahren zum Produzieren einer Wärmeableitungsfolie nach Anspruch 1, die ein Silikonharz und einen wärmeleitenden Füllstoff enthält, umfassend:

einen Zusammensetzungsherstellungsschritt zum Herstellen einer Zusammensetzung durch Mischen von 10 bis 30 Masse-% des Silikonharzes und 70 bis 90 Masse-% des wärmeleitenden Füllstoffs, basierend auf 100 Masse-% der Gesamtmenge des Silikonharzes und des wärmeleitenden Füllstoffs;
einen Folienausbildungsschritt zum Formen der Zusammensetzung in eine Folie nach dem Zusammensetzungsherstellungsschritt;
einen Vorwärmschritt zum Vorwärmen der Folie auf eine Vorwärmtemperatur, die niedriger als eine Härtungsstarttemperatur ist, während eines Ausübens von Druck auf die Folie nach dem Folienausbildungsschritt; und
einen Härtungsschritt zum Erwärmen der vorgewärmten Folie auf eine Temperatur, die gleich oder höher als die Härtungsstarttemperatur ist, während eines Ausübens von Druck auf die Folie nach dem Vorwärmschritt, wobei
ein Druck im Vorwärmschritt $4,9*10^6$ bis $1,96*10^7$ Pa (50 bis 200 kgf/cm$^2$) beträgt,
die Vorwärmtemperatur im Vorwärmschritt 50 bis 80 °C beträgt,
ein Druck im Härtungsschritt $9,6*10^6$ bis $1,96*10^7$ Pa (100 bis 200 kgf/cm$^2$) beträgt, und
die Temperatur im Härtungsschritt 130 bis 200 °C beträgt.

**Revendications**

1. Feuille de dissipation thermique comprenant une résine de silicone et une charge thermoconductrice, dans laquelle

la teneur en résine de silicone est de 10 à 30 % en masse et la teneur en charge thermoconductrice est de 70 à 90 % en masse sur la base de 100 % en masse de la quantité totale de la résine de silicone et de la charge thermoconductrice, et
dans lequel, dans une vue en coupe transversale dans la direction d'épaisseur d'une surface à l'autre surface de la feuille de dissipation thermique, lorsque la forme en coupe transversale de la charge thermoconductrice est telle que le diamètre Feret dans la direction d'épaisseur est représenté par D et le diamètre Feret dans la direction de plan est représenté par W, par rapport aux 1ère à 24ème particules à partir du plus grand de diamètres moyens biaxiaux représentés par la formule (I) :

la valeur moyenne d'un rapport d'aspect représenté par la formule (II) est comprise dans une plage de 0,4 ou plus à 1,4 ou moins, ou
un rapport de surface (Sr) d'une surface totale S de formes en coupe transversale d'une pluralité de particules à une surface totale de la vue en coupe transversale est compris dans une plage de 20 % ou plus à 80 % ou moins, ou
un rapport de nombre de particules, $n_w/n_d$, entre un nombre de particules par 10 $\mu$m d'une ligne droite traversée par la ligne droite tracée à intervalles de 20 $\mu$m parallèlement à la direction de plan, $n_w$, et un nombre de particules par 10 $\mu$m d'une ligne droite traversée par la ligne droite tracée à intervalles de 20 $\mu$m parallèlement à la direction d'épaisseur, $n_d$, est compris dans une plage de 0,4 ou plus et inférieur à 1,

$$(D + W)/2 \qquad (I)$$

$$D/W \qquad (II) ;$$

et

la charge thermoconductrice comprend des particules d'agrégat ayant un diamètre de particule moyen de 30 $\mu$m ou plus, mesuré par diffusion de diffraction laser, et formées par agrégation de particules primaires en forme d'écailles de nitrure de bore,
une proportion des particules d'agrégat dans la quantité totale de la charge thermoconductrice est égale ou supérieure à 90 % en masse, et
une résistance à l'écrasement des particules d'agrégat de 1 à 40 MPa, mesurée conformément à la norme JIS R1639-5.

2. Procédé de fabrication d'une feuille de dissipation thermique selon la revendication 1 comprenant une résine de silicone et une charge thermoconductrice, qui comprend :

une étape de préparation de composition en mélangeant 10 à 30 % en masse de la résine de silicone et 70 à 90 % en masse de la charge thermoconductrice en se basant sur 100 % en masse de la quantité totale de la résine de silicone et de la charge thermoconductrice ;
une étape de formation de feuille consistant à former la composition en une feuille après l'étape de préparation de composition ;
une étape de préchauffage consistant à préchauffer la feuille à une température de préchauffage inférieure à une température de début de durcissement tout en pressurisant la feuille après l'étape de formation de feuille ; et
une étape de durcissement consistant à chauffer la feuille préchauffée à une température égale ou supérieure à la température de début de durcissement tout en pressurisant la feuille après l'étape de préchauffage, dans lequel
une pression dans l'étape de préchauffage est de $4{,}9{*}10^6$ à $1{,}96{*}10^7$ Pa (50 à 200kgf/cm$^2$),
la température de préchauffage dans l'étape de préchauffage est comprise entre 50 et 80°C,
une pression dans l'étape de durcissement est de $9{,}6{*}10^6$ à $1{,}96{*}10^7$ Pa (100 à 200kgf/cm$^2$), et
la température dans l'étape de durcissement est comprise entre 130 et 200°C.

Fig. 1

(a)

2

3

1

(b)

4

Fig. 2

(a)   Thermal conductivity Small

Thermal conductivity Large

(b)   Thermal conductivity Large

Thermal conductivity Large

# Fig. 3

(a)

(b)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014229849 A
- JP 2018104253 A
- JP 2012039060 A

- WO 2019164002 A1
- EP 3522689 A1

**Non-patent literature cited in the description**

- **KENJI MIMURA**. High Heat Conduction Composite Material. *Network Polymer*, 2014, vol. 35 (2), 76-82